# EUROPÄISCHE PATENTSCHRIFT

(11) **EP 3 265 831 B1**
(45) Veröffentlichungstag und Bekanntmachung des Hinweises auf die Patenterteilung: **13.06.2018**
(21) Anmeldenummer: 17716128.8
(22) Anmeldetag: 07.04.2017
(51) Int. Cl.: G01R 1/067, G01R 1/073, G01R 1/04

(54) **KONTAKTSTIFT UND TESTSOCKEL MIT KONTAKTSTIFTEN**
CONTACT PIN AND TEST BASE HAVING CONTACT PINS
BROCHE DE CONTACT ET SOCLE DE TEST MUNI DE BROCHES DE CONTACT

(30) Priorität: 13.04.2016 DE 102016004520
(43) Veröffentlichungstag der Anmeldung: 10.01.2018
(73) Patentinhaber: Rosenberger Hochfrequenztechnik GmbH & Co. KG, 83413 Fridolfing (DE)
(72) Erfinder: REISCHL, Stefan, 83404 Ainring (DE); HUBER, Ludwig, 83413 Fridolfing (DE)
(86) Internationale Anmeldenummer: PCT/EP2017/000445
(87) Internationale Veröffentlichungsnummer: WO 2017/178105

(56) Entgegenhaltungen:
- EP-A1- 0 621 484
- EP-A1- 0 966 687
- EP-A1- 2 919 020
- EP-A2- 1 496 574
- WO-A1-2014/003003
- US-A- 5 764 072
- US-A1- 2002 160 632
- US-A1- 2004 157 476
- US-A1- 2005 179 458
- US-B1- 6 491 968

## Beschreibung

Die Erfindung betrifft einen Kontaktstift und einen Testsockel, welcher mehrere Kontaktstifte enthält.

Eine automatische Testumgebung (englisch: automatic test equipment (ATE)), in der integrierte Schaltungen hinsichtlich ihrer korrekten Funktion geprüft werden, besteht im Wesentlichen aus einem Messgerät, beispielsweise einem Netzwerkanalysator, einem sogenannten Loadboard (deutsch: Lastplatte), die eine Leiterplatte als applikationsspezifische Schnittstelle zwischen dem universell einsetzbaren Messgerät und der integrierten Schaltung als applikationsspezifisches Messobjekt (englisch: device under test (DUT)) darstellt, und einem Handhabungsautomaten, der die integrierte Schaltung in einen auf dem Loadboard befestigten Testsockel einfügt, an den Testsockel andrückt und wieder entfernt.

Für einen vollständigen und korrekten Test der integrierten Schaltung weist der Testsockel eine bestimmte Anzahl von typischerweise in zwei oder vier Reihen jeweils angeordneten Kontaktstiften auf, die jeweils eine optimale elektrische Verbindung zwischen einer Kontaktfläche der zu testenden integrierten Schaltung - die im Folgenden als erste Kontaktfläche bezeichnet wird - und einer zugehörigen, auf dem Testsockel befindlichen Kontaktfläche - die im Folgenden als zweite Kontaktfläche bezeichnet wird - bilden.

Aus der EP 0 906 007 B1 geht ein derartiger Kontaktstift hervor, der die Kontaktfläche einer zu vermessenden integrierten Schaltung mit der Kontaktfläche des Testsockels verbindet.

Ein derartiger Kontaktstift weist zwei elastische Bereiche auf, mit denen jeweils unabhängig voneinander zwei elektrisehe Verbindungen zwischen dem Kontaktstift und jeweils einer der beiden Kontaktflächen erzielt werden kann.

Da die Kontaktflächen von integrierten Schaltungen aus Zinn oder anderen leitenden Kontaktwerkstoffen hergestellt sind, können sich nachteilig durch z.B. Oxidation über der Zeit Schichten an diesen Kontaktflächen bilden, die den elektrischen Kontakt zwischen der Kontaktfläche und dem zugehörigen Kontaktbereich des Kontaktstiftes verschlechtern. Durch eine Reibbewegung der beiden Kontaktbereiche des Kontaktstifts, die jeweils parallel zu den Kontaktflächen verläuft und beim Einsetzen des zu testenden Messobjekts in den Testsockel auftritt, werden Partikel aus diesen beispielsweise Zinnoxid-Schichten entfernt und damit jeweils der elektrische Kontakt wieder hergestellt bzw. verbessert.

Der Kontaktstift der EP 0 906 007 B1 weist aber nachteilig eine vergleichsweise große räumliche Ausdehnung auf. Im Zuge zunehmender Miniaturisierung von integrierten Schaltungen ist ein derartiger Kontaktstift nicht geeignet.

Die EP 0 966 687 A1 offenbart die Anordnung von mehreren Kontaktelementen in einem Testsockel eines automatischen Testsystems.

Die US 2002/0160632 A1 offenbart ein Testsystem, bei dem die in einem bestimmten Raster angeordneten Kontaktelemente in einem Rahmen eingebaut sind, der sich zwischen einer ersten und einer zweiten elektronischen Komponente befindet.

Aus der WO 2014/003003 A1 geht ein Testsockel mit mehreren in einzelnen Reihen jeweils angeordneten Kontaktelementen für Hochtemperaturanwendungen hervor.

Die US 2004/0157476 A1 offenbart eine Testvorrichtung zum Testen von integrierten Schaltungen mit einer Vielzahl von Kontaktelementen, die in einer hohen Packungsdichte zueinander angeordnet sind und im Übergangbereich zu den beiden Elektronik-Komponenten von einer gemeinsamen Dichtung eingerahmt sind.

Aus der EP 2 919 020 A1 gehen Kontaktelemente hervor, die in einem Testsockel drehbar gelagert sind.

In der EP 1 496 574 A2 ist ein IC-Testsockel offenbart, in dem Kontaktelemente mit verlängerten und einen Versatz aufweisenden Federarmen in einer hohen Packungsdichte angeordnet sind.

Die US 2005/0179458 A1 stellt verschiedene Varianten eines elastischen Kontaktelements mit mehreren parallel verlaufenden Federarmen vor.

Aus der US 6,491,968 B1 geht ein Verfahren zur Herstellung eines Kontaktelements mit mehreren parallel verlaufenden Federarmen hervor.

In der EP 0 621 484 A1 sind in einem Testsockel die Federarme von in einzelnen Reihen jeweils angeordneten Kontaktelementen über Abstands-Strukturen voneinander beabstandet und geführt.

In der US 5,764,072 A werden die beiden Federarme von mehreren Kontaktelementen über eine Ausrichtungsplatte zueinander ausgerichtet.

Aufgabe der Erfindung ist es deshalb, einen Kontaktstift und ein diese Kontaktstifte enthaltenden Testsockel zu schaffen, der den im Zusammenhang mit EP 0 906 007 B1 genannten Nachteil überwindet.

Die Aufgabe wird durch einen erfindungsgemäßen Kontaktstift mit den Merkmalen des Patentanspruchs 1 und durch einen erfindungsgemäßen Testsockel mit den Merkmalen des Patentanspruchs 16 gelöst. Vorteilhafte technische Erweiterungen sind in den jeweils abhängigen Patentansprüchen berücksichtigt.

Der Kontaktstift gemäß Patentanspruch 1 weist einen Mittelbereich und als Elastizitäten zwei Federarme auf. Der erste und zweite Federarm ist jeweils mit seinem ersten Ende mit dem Mittelbereich verbunden und weist an seinem zweiten Ende jeweils einen Kontaktbereich zur elektrischen Kontaktierung mit der ersten Kontaktfläche des zu vermessenden Messobjekts bzw. mit der zweiten Kontaktfläche des Testsockels auf. Im Folgenden wird der Kontaktbereich des ersten Federarms als erster Kontaktbereich und der Kontaktbereich des zweiten Federarms als zweiter Kontaktbereich bezeichnet.

Um den erfindungsgemäßen Kontaktstift möglichst raumsparend zu gestalten, werden das erste Ende des ersten Federarms mit einem ersten Ende des im Wesentlichen länglich ausgeführten Mittelbereichs und das erste Ende des zweiten Federarms mit dem ersten Ende oder dem zweiten Ende des Mittelbereiches verbunden. Außerdem sind der erste und zweite Federarm im Bereich ihres ersten Endes jeweils in einem Winkel zur Mittelachse des Mittelbereichs orientiert, der kleiner oder gleich 90° ist.

Beide technische Maßnahmen ermöglichen vorteilhaft, dass der Kontaktstift mit seinen beiden Federarmen, deren Längen jeweils funktionsbedingt am wesentlichsten die Ausdehnung des Kontaktstiftes beeinflussen, ein minimiertes geometrisches Volumen aufweist. Daneben weist ein miniaturisierter Kontaktstift kürzere Signalpfade auf und optimiert somit zusätzlich die Hochfrequenz-Übertragungscharakteristik des Kontaktstifts.

Eine zusätzliche mechanische Stabilisierung des Federstifts wird erfindungsgemäß durch den charakterisierenden Teil des Anspruchs 1 verwirklicht. In einer bevorzugten Variante sind der erste und der zweite Federarm mit ihren ersten Enden jeweils an einem unterschiedlichen Ende des Mittelbereiches mit dem Mittelbereich verbunden. Alternativ ist auch eine zweite Variante realisierbar, in der der erste und der zweite Federarm mit ihren ersten Enden jeweils am selben Ende des Mittelbereiches mit dem Mittelbereich verbunden sind.

Um die Länge des ersten und zweiten Federarms bei gleichbleibender Gesamtelastizität des Kontaktstifts weiterhin im Hinblick auf eine weitere Miniaturisierung des erfindungsgemäßen Kontaktstiftes zu verkürzen, sind bevorzugt in einer ersten Erweiterung des erfindungsgemäßen Kontaktstiftes parallel zum ersten und zweiten Federarm weitere erste Federarme und/oder weitere zweite Federarme mit dem Mittelbereich verbunden. Die Federarme verjüngen sich in Richtung der Kontaktbereiche. Der erste Federarm, der zweite Federarm und die weiteren ersten und zweiten Federarme sind hierbei vorteilhaft durch jeweils einen Schlitz voneinander beabstandet, der beim verwendeten LIGA(Lithographie-Galvanik-Abformung)-Prozess für den Kontaktstift typischerweise in der gleichen Größenordnung wie die durchschnittliche Breite der Federarme ist. Bei Anwendung eines anderen Fertigungsprozesses sind auch Schlitze realisierbar, die deutlich kleiner als die durchschnittliche Breite der Federarme sind. Die zweiten Enden der weiteren ersten und zweiten Federarme sind mit dem ersten Federarm bzw. dem zweiten Federarm verbunden, wenn das zu testende Messobjekt mit einem Stempel des Handhabungsautomaten in den Testsockel gedrückt wird.

Um die mechanische Stabilität des erfindungsgemäßen Kontaktstifts zu erhöhen, sind die zweiten Enden der weiteren ersten Federarme und der weiteren zweiten Federarme in einer zweiten Erweiterung der Erfindung mit einer lateralen Erweiterung des zweiten Endes des ersten bzw. zweiten Federarms mittels Steckverbindung verbunden.

Hierzu sind in einer ersten Untervariante der zweiten Erweiterung der Erfindung die zweiten Enden der weiteren ersten Federarme und der weiteren zweiten Federarme jeweils als stiftförmige Erweiterungen ausgeformt, die in zugehörigen Vertiefungen in der lateralen Erweiterung des zweiten Endes des ersten Federarms bzw. des zweiten Federarms eingeführt und gesteckt sind.

In einer zweiten Untervariante der zweiten Erweiterung der Erfindung weisen die zweiten Enden der weiteren ersten Federarme und der weiteren zweiten Federarme jeweils eine Vertiefung auf, in die zugehörige zusätzliche stiftförmige Erweiterungen eingeführt und gesteckt sind, die in der lateralen Erweiterung des zweiten Endes des ersten Federarms bzw. des zweiten Federarms ausgeformt sind.

Anstelle einer fixen Verbindung zwischen den ersten Enden der weiteren ersten und der weiteren zweiten Federarme und dem Mittelbereich kann alternativ in einer dritten Erweiterung der Erfindung auch eine Steckverbindung zwischen den ersten Enden der weiteren ersten und der weiteren zweiten Federarme und dem Mittelbereich realisiert sein:
In einer ersten Untervariante der dritten Erweiterung der Erfindung sind die ersten Enden der weiteren ersten und
zweiten Federarme als stiftförmige Erweiterungen ausgeformt, die in zugehörigen Vertiefungen des Mittelbereiches eingeführt und gesteckt sind. Alternativ sind in einer zweiten Untervariante der dritten erfindungsgemäßen Variante im Mittelbereich stiftförmige Erweiterungen ausgeformt, die in zugehörigen Vertiefungen an den ersten Enden der weiteren ersten und zweiten Federarme eingeführt und gesteckt sind.

In einer ersten Untervariante einer vierten Erweiterung der Erfindung weist die laterale Erweiterung des zweiten Endes des ersten Federarms und/oder des zweiten Federarms jeweils eine Vertiefung auf, wobei in die Vertiefung am zweiten Ende des ersten Federarms die laterale stiftförmige Erweiterung des zweiten Endes des Mittelbereiches und/oder in die Vertiefung am zweiten Ende des zweiten Federarms die laterale stiftförmige Erweiterung des zweiten Endes bzw. des ersten Endes des Mittelbereiches eingeführt und gesteckt ist.

Alternativ ist in einer zweiten Untervariante der vierten Erweiterung der Erfindung die laterale Erweiterung des zweiten Endes des ersten Federarms und/oder des zweiten Federarms stiftförmig ausgeformt, wobei die stiftförmige laterale Erweiterung des zweiten Endes des ersten Federarms in einer zugehörigen am zweiten Ende des Mittelbereiches ausgeformten Vertiefung eingeführt und gesteckt ist und/oder die stiftförmige laterale Erweiterung des zweiten Endes des zweiten Federarms in einer zugehörigen am zweiten bzw. ersten Ende des Mittelbereiches ausgeformten Vertiefung eingeführt und gesteckt ist.

Bevorzugt verlaufen die einzelnen ersten und zweiten Federarme in einer ersten Ausprägungsform jeweils linear, da in dieser ersten Ausprägungsform die Kombination aus minimiertem Volumen und maximierter Elastizität optimiert ist, sofern weitere erste und zweite Federarme vorgesehen sind.

In einer zweiten Ausprägungsform von Federarmen verlaufen die einzelnen ersten und zweiten Federarme jeweils konkav gebogen zum Mittelbereich. Hierbei wird eine geringfügig höhere Elastizität erzielt, da die Federarme geringfügig länger sind, während das erforderliche Volumen gegenüber der ersten Ausprägung geringfügig vergrößert ist.

In einer dritten Ausprägungsform von Federarmen weisen die einzelnen ersten und zweiten Federarme jeweils einen konvex gebogenen Verlauf zum Mittelbereich auf. Das erforderliche Volumen ist bei dieser Ausprägung eines Kontaktstifts am geringsten. Die Elastizität des Kontaktstifts ist aber deutlich schlechter, da in dieser Ausprägung nur wenige weitere erste und zweite Federarme realisierbar sind, die zusätzlich deutlich kürzer ausgeformt sind.

Innerhalb einer vierten Ausprägungsform sind die ersten und zweiten Federarme mäanderförmig ausgeformt. Aufgrund der Mäanderform weisen die ersten und zweiten Federarme jeweils die größte Länge auf. Die vierte Ausprägungsform eines Kontaktstiftes ist für Applikationen geeignet, die eine deutlich geringere Breite bei geringeren Anforderungen an die Höhe erfordern. Um einen möglichst guten Abreibvorgang zwischen dem ersten Kontaktbereich des Kontaktstiftes und der ersten Kontaktfläche am Messobjekt und gleichzeitig einen möglichst geringen Abreibvorgang zwischen dem zweiten Kontaktbereich des Kontaktstiftes und der zweiten Kontaktfläche am Testsockel zu erzielen, ist der Winkel zwischen einer Achse, die zwischen dem ersten und zweiten Ende des ersten Federarms verläuft, und der Längsachse des Mittelbereichs signifikant größer als der Winkel zwischen einer Achse, die zwischen dem ersten und zweiten Ende des zweiten Federarms verläuft, und der Längsachse des Mittelbereichs ausgelegt.

Der Winkel zwischen der Achse, die zwischen dem ersten und zweiten Ende des ersten Federarms verläuft, und der Längsachse des Mittelbereichs ist beispielsweise um den Faktor 1,5 größer als der Winkel zwischen der Achse, die zwischen dem ersten und zweiten Ende des zweiten Federarms verläuft, und der Längsachse des Mittelbereichs. Der Winkel zwischen der Achse, die zwischen dem ersten und zweiten Ende des ersten Federarms verläuft, und der Längsachse des Mittelbereichs ist bevorzugt um den Faktor 2,0 größer als der Winkel zwischen der Achse, die zwischen dem ersten und zweiten Ende des zweiten Federarms verläuft, und der Längsachse des Mittelbereichs. Der Winkel zwischen der Achse, die zwischen dem ersten und zweiten Ende des ersten Federarms verläuft, und der Längsachse des Mittelbereichs ist besonders bevorzugt um den Faktor 2,5 größer als der Winkel zwischen der Achse, die zwischen dem ersten und zweiten Ende des zweiten Federarms verläuft, und der Längsachse des Mittelbereichs.

Der größere Winkel zwischen der Achse, die zwischen dem ersten und zweiten Ende des ersten Federarms verläuft, und der Längsachse des Mittelbereichs gegenüber dem Winkel zwischen der Achse, die zwischen dem ersten und zweiten Ende des zweiten Federarms verläuft, und der Längsachse des Mittelbereichs bewirkt bei näherungsweise gleiche Länge des ersten und zweiten Federarms eine Bewegung des ersten Kontaktbereichs in paralleler Richtung zur ersten Kontaktfläche, die größer als die Bewegung des zweiten Kontaktbereichs in paralleler Richtung zur zweiten Kontaktfläche ist.

Die längere Bewegung des ersten Kontaktbereichs an der ersten Kontaktfläche gegenüber der Bewegung des zweiten Kontaktbereichs an der zweiten Kontaktfläche bewirkt ein großflächigeres Abschaben von beispielsweise Zinnoxid-Partikeln an der ersten Kontaktfläche, insbesondere ein Abschaben von beispielsweise Zinnoxid-Partikeln im Bereich der Kontaktspitze des Kontaktbereichs, die den elektrischen Kontakt zur ersten Kontaktfläche bildet.

Im erfindungsgemäßen Testsockel ist eine der Anzahl von ersten Kontaktflächen des DUTs entsprechende Anzahl von erfindungsgemäßen Kontaktstiften angeordnet. Die Anordnung der erfindungsgemäßen Kontaktstifte erfolgt typischerweise in Analogie zur Anordnung der ersten Kontaktflächen bei einer integrierten Schaltung in zwei oder vier Reihen, die um einen bestimmten Versatz versetzt zur Lage der zwei bzw. vier Seiten der rechteckigen Grundfläche der integrierten Schaltung angeordnet sind. Eine andere Anordnung von erfindungsgemäßen Kontaktstiften innerhalb eines erfindungsgemäßen Testsockels, beispielsweise in einer Gitter- oder Matrixanordnung, und jede zukünftig verwendete Anordnung von erfindungsgemäßen Kontaktstiften ist ebenfalls möglich und von der Erfindung mit abgedeckt.

Die einzelnen erfindungsgemäßen Kontaktstifte sind über jeweils mindestens eine Befestigungsvorrichtung mit dem erfindungsgemäßen Testsockel mechanisch verbunden und stehen jeweils mit zugehörigen zweiten Kontaktflächen des erfindungsgemäßen Testsockels in einem elektrischen Kontakt. Alternativ können die einzelnen erfindungsgemäßen Kontaktstifte auch in einem Modul integriert sein, das vom erfindungsgemäßen Testsockel trennbar ist. Schließlich können die einzelnen erfindungsgemäßen Kontaktstifte einer einzigen Reihe in einem Modul integriert sein, das ebenfalls vom erfindungsgemäßen Testsockel trennbar ist.

Die einzelnen Ausprägungsformen, Varianten, Untervarianten und Erweiterungen des erfindungsgemäßen Kontaktstiftes und des erfindungsgemäßen Testsockels sowie Beispiele eines Kontaktstiftes der nicht Teil der Erfindung ist, werden im Folgenden anhand der Zeichnung im Detail erläutert. Die Figuren der Zeichnung zeigen:
- Fig. 1: eine Darstellung eines ersten Beispiels eines nicht erfindungsgemäßen Kontaktstiftes mit einem linear verlaufenden Federarm pro Kontaktseite,
- Fig. 2A: eine Darstellung einer ersten Variante einer ersten Erweiterung eines ersten Beispiels eines nicht erfindungsgemäßen Kontaktstiftes,
- Fig. 2B: eine Darstellung einer zweiten Variante einer ersten Erweiterung eines ersten Beispiels eines nicht erfindungsgemäßen Kontaktstiftes,
- Fig. 3A: eine Darstellung einer ersten Untervariante einer zweiten Erweiterung eines erfindungsgemäßen Kontaktstiftes,
- Fig. 3B: eine Darstellung einer zweiten Untervariante einer zweiten Erweiterung eines erfindungsgemäßen Kontaktstiftes,

- Fig. 4A: eine Darstellung einer ersten Untervariante einer dritten Erweiterung eines erfindungsgemäßen Kontaktstiftes,
- Fig. 4B: eine Darstellung einer zweiten Untervariante einer dritten Erweiterung eines erfindungsgemäßen Kontaktstiftes,
- Fig. 5A: eine Darstellung einer ersten Untervariante einer vierten Erweiterung eines erfindungsgemäßen Kontaktstiftes,
- Fig. 5B: eine Darstellung einer zweiten Untervariante einer vierten Erweiterung eines erfindungsgemäßen Kontaktstiftes,
- Fig. 6A: eine Darstellung eines zweiten Beispiels eines nicht erfindungsgemäßen Kontaktstifts,
- Fig. 6B: eine Darstellung eines dritten Beispiels eines nicht erfindungsgemäßen Kontaktstifts,
- Fig. 6C: eine Darstellung eines vierten Beispiels eines nicht erfindungsgemäßen Kontaktstifts,
- Fig. 7: eine Darstellung eines Kontaktstiftes mit unterschiedlichen Längen der Abreibwege an den einzelnen Kontaktseiten,
- Fig. 8A: eine Darstellung eines erfindungsgemäßen Testsockels in der Draufsicht,
- Fig. 8B: eine seitliche Querschnittsdarstellung eines erfindungsgemäßen Testsockels,

- Fig. 8C: eine dreidimensionale Darstellung eines erfindungsgemäßen Testsockels mit eingelagerten Modulen,
- Fig. 8D: eine dreidimensionale Darstellung eines erfindungsgemäßen Testsockels mit ausgelagerten Modulen und
- Fig. 9: eine Darstellung eines erfindungsgemäßen Kontaktstifts mit einzelnen Signalpfaden.

Im Folgenden werden die einzelnen Ausprägungsformen, Varianten, Untervarianten und Erweiterungen des erfindungsgemäßen Kontaktstiftes sowie Beispiele eines nicht erfindungsgemäßen Kontaktstiftes anhand der Figuren im Detail erläutert:

Der erfindungsgemäße Kontaktstift stellt ein mikromechanisches Bauteil dar. Der erfindungsgemäße Kontaktstift wird bevorzugt mittels LIGA-Prozess hergestellt. Daneben sind andere mikromechanische Prozesse für die Herstellung des erfindungsgemäßen Kontaktstiftes ebenfalls möglich und von der Erfindung mit abgedeckt.

Aufgrund des mikromechanischen Prozesses weist der erfindungsgemäße Kontaktstift bei einer homogenen Dicke eine primär zweidimensionale Geometrie (Höhe und Breite des erfindungsgemäßen Kontaktstiftes) auf. Die Höhe und Breite des erfindungsgemäßen Kontaktstiftes liegt jeweils typischerweise zwischen einem und drei Millimeter, während die Dicke typischerweise ungefähr einem Zehntel Millimeter beträgt.

Bei einer bevorzugten Anwendung des LIGA-Prozesses besteht der erfindungsgemäße Kontaktstift typischerweise aus einem Metall, Metalllegierungen oder Verbindungsystemen aus metallischen und nichtmetallischen Elementen z.B. NiP. Die Seitenflächen an den Übergängen zwischen der Ober- und Unterseite des primär in der Höhe und der Breite ausgerichteten erfindungsgemäßen Kontaktstiftes ist mit einer Beschichtung, beispielsweise einer Goldbeschichtung, versehen.

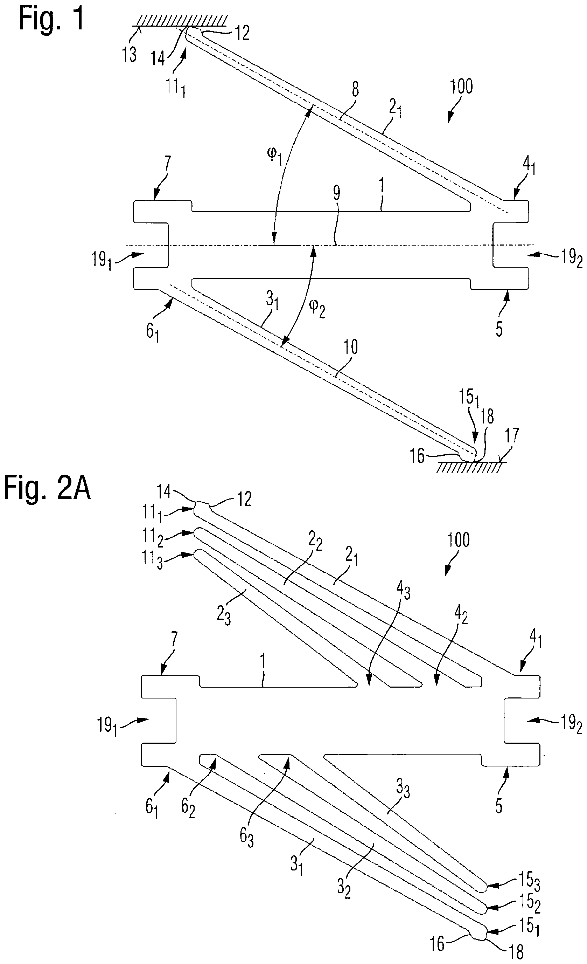

In einem ersten, stark vereinfachten Beispiel eines Kontaktstiftes 100 gemäß Fig. 1, die eine zweidimensionale Darstellung des Kontaktstiftes in den Dimensionen Höhe und Breite zeigt, besteht der Kontaktstift 100 aus einem länglich ausgeformten Mittelbereich 1, einem ersten Federarm 2₁ und einem zweiten Federarm 3₁. Der erste und zweite Federarm 2₁ und 3₁ weisen jeweils eine längliche lineare Ausformung auf, deren Breite jeweils typischerweise geringer als die Breite des Mittelbereiches 1 ausgeprägt ist.

Der erste Federarm 2₁ ist an seinem ersten Ende 4₁ mit einem ersten Ende 5 des Mittelbereiches 1 - mit dem in Fig. 1 rechtsseitig dargestellten Ende des Mittelbereiches - verbunden. Der zweite Federarm 3₁ ist an seinem ersten Ende 6₁ mit dem zweiten Ende 7 des Mittelbereiches 1 - mit dem in Fig. 1 linksseitig dargestellten Ende 7 des Mittelbereiches 1 - verbunden.

Der erste und zweite Federarm 2₁ und 3₁ sind jeweils im Bereich ihres ersten Endes 4₁ bzw. 6₁ in einen Winkel Φ₁ bzw. φ₂, der kleiner oder gleich 90° ist, zum Mittelbereich 1 orientiert. Hierbei ergibt sich der Orientierungswinkel φ₁ zwischen dem ersten Federarm 2₁ im Bereich ihres ersten Endes 4₁ und dem Mittelbereich 1 als Winkel zwischen einer Tangente an der ersten Feder 2₁ im Bereich ihres ersten Endes 4₁ und der innerhalb des Mittelbereiches 1 befindlichen Längsachse 9 des Mittelbereichs 1, der im Fall eines linearen ersten Federarms 2₁ dem Winkel zwischen der Längsachse 8 des ersten Federarms 2₁, d.h. der Achse zwischen dem ersten Ende 4₁ und dem zweiten Ende 11₁ des ersten Federarms 3₁, und der innerhalb des Mittelbereiches 1 befindlichen Längsachse 9 des Mittelbereiches 1, entspricht. Der Orientierungswinkel φ₂ ergibt sich äquivalent als Winkel zwischen einer Tangente an der zweiten Feder 3₁ im Bereich ihres ersten Endes 6₁ und der Längsachse 9 des Mittelbereichs 1, der im Fall eines linearen zweiten Federarms 3₁ dem Winkel zwischen der Längsachse 10 des zweiten Federarms 3₁, d.h. der Achse zwischen dem ersten Ende 6₁ und dem zweiten Ende 15₁ des zweiten Federarms 3₁, und der Längsachse 9 des Mittelbereiches 1, entspricht.

Am zweiten Ende 11₁ des ersten Federarms 2₁ ist ein erster Kontaktbereich 12 ausgeformt, der bei eingedrückten Zustand des zu vermessenden Messobjekts, d.h. der zu vermessenden integrierten Schaltung, in den Testsockel einen elektrischen Kontakt zu einer zugehörigen ersten Kontaktfläche 13 des Messobjekts bildet.

Wie aus Fig. 1 hervorgeht, besteht dieser erste Kontaktbereich 12 bevorzugt aus einer in Richtung der ersten Kontaktfläche 13 weisenden, wulstförmigen Erweiterung mit einer Kontaktzone 14, die den eigentlichen elektrischen Kontakt mit der ersten Kontaktfläche 13 des Messobjekts herstellt.

Daneben weist der erste Kontaktbereich 12 eine in Fig. 1 nicht dargestellte Erhebung oder Spitze auf, die beim Einsetzen des zu vermessenden Messobjekts in den Testsockel zusammen mit dem ersten Kontaktbereich 12 eine geringfügige translatorische Bewegung an der ersten Kontaktfläche 13 ausführt. Aufgrund der Federkraft des ersten Federarms 2₁ und der scharfkantigen Ausprägung der zusätzlichen Erhebung oder Spitze werden durch die translatorische Bewegung des ersten Kontaktbereichs 12 Partikel einer Oxid-Schicht auf der ersten Kontaktfläche 13 abgeschabt. Diese Oxid-Schicht auf der ersten Kontaktfläche 13 bildet sich aufgrund von Oxidation im Laufe der Zeit und verschlechtert den elektrischen Kontakt. Durch das Abschaben der Partikel dieser Oxid-Schicht wird der elektrische Kontakt zwischen der ersten Kontaktfläche 13 und dem ersten Kontaktbereich 12 des ersten Federarms 2₁ wieder verbessert.

Am zweiten Ende 15₁ des zweiten Federarms 3₁ ist ein zweiter Kontaktbereich 16 ausgeformt, der eine in Richtung einer zweiten Kontaktfläche 17 im Testsockel weisende, wulstförmige Erweiterung mit einer Kontaktspitze 18 darstellt. Diese Kontaktspitze 18 bildet den eigentlichen elektrischen Kontakt zwischen dem zweiten Kontaktbereich 16 des zweiten Federarms 3₁ und der zweiten Kontaktfläche 17 im Testsockel. Zur mechanischen Befestigung des Kontaktstiftes 100 im Testsockel ist im Mittelbereich 1 mindestens ein Rastmittel vorgesehen. In der Darstellung der Fig. 1 sind beispielsweise an den beiden Enden des Mittelbereiches 1 jeweils ein Rastmittel 19₁ und 19₂ vorgesehen, die jeweils mit einem korrespondierenden Rastmittel im Testsockel eine formschlüssige Verbindung bilden. Alternativ zur formschlüssigen Verbindung ist von der Erfindung auch eine kraftschlüssige Verbindung zwischen Kontaktstift und Testsockel mit abgedeckt. Hierbei steht ein Kontaktmittel im Kontaktstift 100 oder im Testsockel mit einer korrespondierenden Kontaktfläche im Testsockel bzw. im Kontaktstift 100 im Kraftschluss.

Durch die Federkraft, die der erste Federarm 2₁ des Kontaktstiftes auf die erste Kontaktfläche 13 des zu vermessenden Messobjekts und der zweite Federarm 3₁ auf die zweite Kontaktfläche 17 im Testsockel ausübt, ist eine ausreichende elektrische Verbindung zwischen der ersten Kontaktfläche 13 des zu vermessenden Messobjekts und dem Kontaktstift bzw. zwischen dem Kontaktstift 100 und der zweiten Kontaktfläche 17 im Testsockel garantiert.

Um die Länge des ersten Federarms 2₁ und des zweiten Federarms 3₁ zu verkürzen und damit den Kontaktstift 100 zusätzlich zu verkleinern, weist ein Kontaktstift 100 in einer ersten Erweiterung zusätzlich zum ersten Federarm 2₁ weitere erste Federarme 2₂ und 2₃ und zusätzlich zum zweiten Federarm 3₁ weitere zweite Federarme 3₂ und 3₃ auf.

In einer ersten Untervariante der ersten Erweiterung des Kontaktstiftes 100 gemäß Fig. 2A verlaufen diese weiteren ersten Federarme 2₂ und 2₃ parallel zum ersten Federarm 2₁ und sind mit ihren ersten Enden 4₂ bzw. 4₃ am ersten Ende 5 des Mittelbereiches 1 bzw. benachbart zum ersten Ende 5 des Mittelbereiches 1 mit dem Mittelbereich 1 verbunden. Die einzelnen ersten Federarme 2₁, 2₂ und 2₃ sind jeweils durch einen Schlitz voneinander getrennt, dessen durchschnittliche Breite typischerweise in der Größenordnung der durchschnittlichen Breite der einzelnen ersten Federarme 2₁, 2₂ und 2₃ liegt.

Auch der zweite Federarm 3₁ und die weiteren zweiten Federarme 3₂ und 3₃ verlaufen parallel zueinander und sind mit ihren ersten Enden 6₂ und 6₃ am zweiten Ende 7 des Mittelbereiches 1 bzw. benachbart zum zweiten Ende 7 des Mittelbereiches 1 mit dem Mittelbereich 1 verbunden. Auch die einzelnen zweiten Federarme 6₁, 6₂ und 6₃ sind jeweils durch einen Schlitz voneinander getrennt, dessen durchschnittliche Breite typischerweise in der Größenordnung der durchschnittlichen Breite der einzelnen zweiten Federarme 3₁, 3₂ und 3₃ liegt.

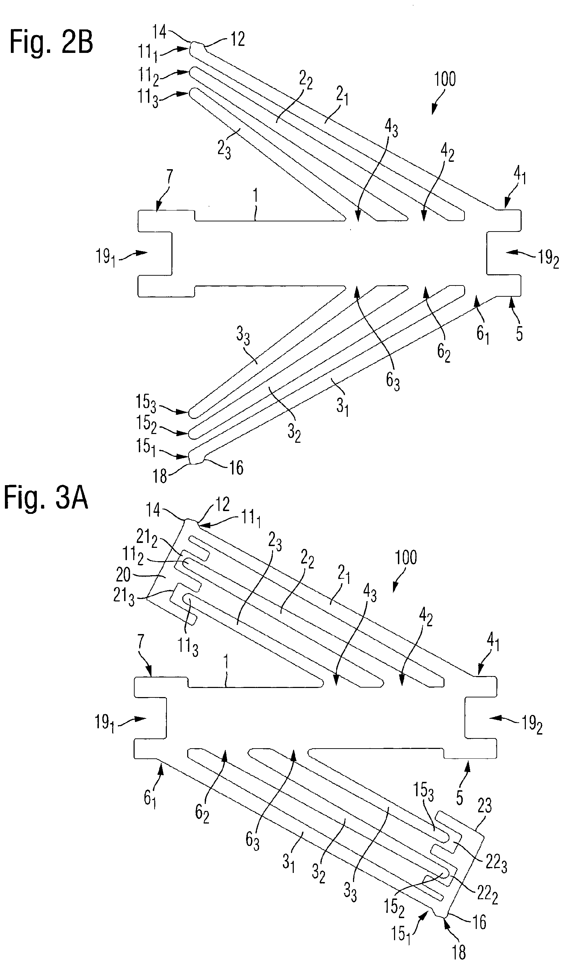

Die Anzahl der parallelen ersten und zweiten Federarme ist nicht wie in Fig. 2A beschränkt. Von der Erfindung ist auch jede beliebige andere Anzahl von parallelen ersten bzw. zweiten Federarmen abgedeckt, sofern sie entlang der Länge des Mittelbereiches 1 mit dem Mittelbereich 1 unter Zwischenschaltung eines jeweiligen Schlitzes zu verbinden sind. In einer zweiten Untervariante der ersten Erweiterung des Kontaktstifts 100, die in Fig. 2B dargestellt ist, sind der zweite Federarm 3₁ und alle weiteren zweiten Federarme 3₂ und 3₃ am selben Ende bzw. benachbart zum selben Ende des Mittelbereiches 1 - nämlich am ersten Ende 5 und benachbart zum ersten Ende 5 des Mittelbereiches 1 mit dem Mittelbereich 1 verbunden -, an dem auch der erste Federarm 2₁ und alle weiteren ersten Federarme 2₂ und 2₃ mit dem Mittelbereich 1 verbunden sind.

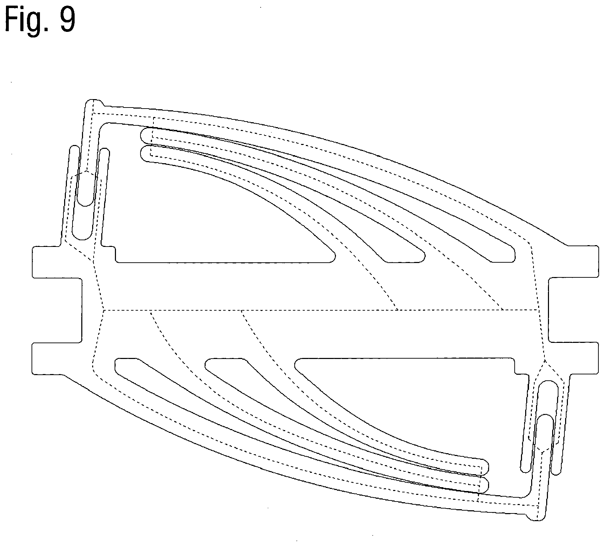

In der ersten Erweiterung des Kontaktstiftes 100 weisen alle weiteren ersten Federarme 2₂ und 2₃ und alle weiteren zweiten Federarme 3₂ und 3₃ jeweils zweite Enden 11₂, 11₃ bzw. 15₂, 15₃ auf, die im gedrückten Zustand des zu vermessenden Messobjekts im Testsockel den ersten Federarm 2₁ bzw. den zweiten Federarm 3₁ berühren, wie in Fig. 9 dargestellt ist. Auf diese Weise entstehen über die weiteren ersten Federarme 2₂ und 2₃ und die weiteren zweiten Federarme 3₂ und 3₃ zusätzliche Signalpfade, die das Hochfrequenz-Übertragungsverhalten des erfindungsgemäßen Kontaktstiftes 100 zusätzlich vorteilhaft verbessern.

In einer zweiten Erweiterung des erfindungsgemäßen Kontaktstiftes 100 sind die zweiten Enden 11₂, 11₃ und 15₂, 15₃ der weiteren ersten Federarme 2₂ und 2₃ bzw. weiteren zweiten Federarme 3₂ und 3₃ jeweils mit einer lateralen Erweiterung des zweiten Endes 11₁ des ersten Federarms 2₁ bzw. mit einer lateralen Erweiterung des zweiten Endes 15₁ des ersten Federarms 3₁ verbunden.

Hierzu weist in einer ersten Untervariante der zweiten Erweiterung des erfindungsgemäßen Kontaktstiftes 100 gemäß Fig. 3A die laterale Erweiterung 20 des zweiten Endes 11₁ des ersten Federarms 2₁ jeweils mehrere Vertiefungen 21₂ und 21₃ auf, in die die zweiten Enden 11₂ und 11₃ der weiteren ersten Federarme 2₂ und 2₃ jeweils hineingeführt und gesteckt sind. Die zweiten Enden 11₂ und 11₃ der weiteren ersten Federarme 2₂ und 2₃ bilden mit den zugehörigen Vertiefungen 21₂ und 21₃ in der lateralen Erweiterung 20 des zweiten Endes 11₁ des ersten Federarms 2₁ jeweils eine Steckverbindung. In dieser Steckverbindung weisen die einzelnen zweiten Enden 11₂ und 11₃ der weiteren ersten Federarme 2₂ und 2₃ gegenüber den zugehörigen Vertiefungen 21₂ und 21₃ eine gewisse axiale und radiale Gleitmöglichkeit auf. Sie sind aber in ihrer axialen und radialen Relativbewegung zur zugehörigen Vertiefung 21₂ und 21₃ begrenzt.

Äquivalent hierzu sind die zweiten Enden 15₂ und 15₃ der weiteren zweiten Federarme 3₂ und 3₃ jeweils in zugehörigen Vertiefungen 22₂ und 22₃ einer lateralen Erweiterung 23 des zweiten Endes 15₁ des zweiten Federarms 3₁ jeweils eingeführt und gesteckt. Auch die zweiten Enden 15₂ und 15₃ der weiteren zweiten Federarme 3₂ und 3₃ bilden mit den zugehörigen Vertiefungen 22₂ und 22₃ der lateralen Erweiterung 23 des zweiten Endes 15₁ des zweiten Federarms 3₁ jeweils eine Steckverbindung.

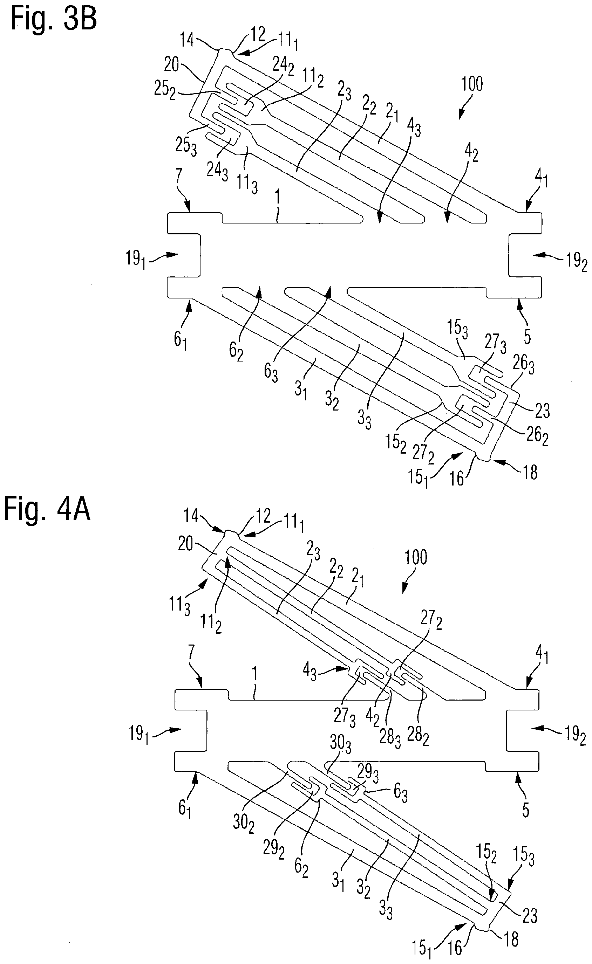

In einer zweiten Untervariante der zweiten Erweiterung des erfindungsgemäßen Kontaktstiftes 100, die in Fig. 3B dargestellt ist, weisen die zweiten Enden 11₂ und 11₃ der weiteren ersten Federarme 3₂ und 3₃ jeweils eine Vertiefung 24₂ bzw. 24₃ auf. In diese Vertiefungen 24₂ und 24₃ sind zugehörige stiftförmige Erweiterungen 25₂ bzw. 25₃ der lateralen Erweiterung 20 des zweiten Endes 11₁ des ersten Federarms 2₁ eingeführt und gesteckt. Diese stiftförmige Erweiterungen 25₂ bzw. 25₃ sind wiederum näherungsweise lateral, d.h. in einem Winkel von näherungsweise 90°, zur lateralen Erweiterung 20 des zweiten Endes 11₁ des ersten Federarms 2₁ ausgerichtet. Die stiftförmigen Erweiterungen 25₂ und 25₃ bilden mit den zugehörigen Vertiefungen 24₂ bzw. 24₃ an den zweiten Enden 11₂ und 11₃ der weiteren ersten Federarme 2₂ und 2₃ jeweils eine Steckverbindung.

Äquivalent sind stiftförmige Erweiterungen 26₂ und 26₃ an der lateralen Erweiterung 23 des zweiten Endes 15₁ des zweiten Federarms 3₁ in zugehörigen Vertiefungen 27₂ bzw. 27₃ an den zweiten Enden 15₂ bzw. 15₃ der weiteren zweiten Federarme 3₂ bzw. 3₃ eingeführt und gesteckt. Diese stiftförmigen Erweiterungen 26₂ und 26₃ sind ebenfalls näherungsweise lateral, d.h. in einem Winkel von näherungsweise 90°, zur lateralen Erweiterung 23 des zweiten Endes 15₁ des zweiten Federarms 3₁ ausgerichtet. Die stiftförmigen Erweiterungen 26₂ und 26₃ bilden ebenfalls mit den zugehörigen Vertiefungen 27₂ bzw. 27₃ an den zweiten Enden 15₂ bzw. 15₃ der weiteren zweiten Federarme 3₂ bzw. 3₃ jeweils eine Steckverbindung.

In einer dritten Erweiterung des erfindungsgemäßen Kontaktstiftes 100 gemäß Fig. 4A bilden die ersten Enden der weiteren ersten und zweiten Federarme mit dem Mittelbereich 1 jeweils eine Steckverbindung, während die zweiten Enden der weiteren ersten und zweiten Federarme mit den jeweiligen lateralen Erweiterungen der zweiten Enden des ersten und zweiten Federarms jeweils fest verbunden sind.

Hierbei weisen in einer ersten Untervariante der dritten Erweiterung des erfindungsgemäßen Kontaktstiftes 100 die ersten Enden 4₂ und 4₃ der weiteren ersten Federarme 2₂ bzw. 2₃ jeweils eine Vertiefung 27₂ bzw. 27₃ auf, während die zweiten Enden 11₂ und 11₃ der weiteren ersten Federarme 2₂ bzw. 2₃ mit der lateralen Erweiterung 20 des ersten Endes 11₁ des ersten Federarms 2₁ fest verbunden sind.

In den Vertiefungen 27₂ und 27₃ an den ersten Enden 4₂ und 4₃ der weiteren ersten Federarme 2₂ bzw. 2₃ sind zugehörige laterale Erweiterungen 28₂ und 28₃ des Mittelbereiches 1 eingeführt und gesteckt. Diese lateralen Erweiterungen 28₂ und 28₃ weisen die gleiche Orientierung wie die weiteren ersten Federarme 2₂ und 2₃ auf und ragen an passenden Positionen des Mittelbereiches 1 benachbart zum ersten Ende 5 des Mittelbereiches 1 aus dem Mittelbereich 1 heraus. Damit ist gewährleistet, dass die weiteren ersten Federarme 2₂ und 2₃ parallel zum ersten Federarm 2₁ und voneinander jeweils beabstandet durch einen Schlitz, dessen durchschnittliche Breite näherungsweise der durchschnittlichen Breite der einzelnen ersten Federarme 2₁, 2₂ und 2₃ entspricht, angeordnet sind. Die lateralen Erweiterungen 28₂ und 28₃ des Mittelbereiches 1 bilden mit den zugehörigen Vertiefungen 27₂ und 27₃ an den ersten Enden 4₂ und 4₃ der weiteren ersten Federarme 2₂ bzw. 2₃ jeweils eine Steckverbindung.

Äquivalent weisen die ersten Enden 6₂ und 6₃ der weiteren zweiten Federarme 3₂ bzw. 3₃ jeweils eine Vertiefung 29₂ bzw. 29₃ auf, während die zweiten Enden 15₂ und 15₃ der weiteren zweiten Federarme 3₂ bzw. 3₃ mit der lateralen Erweiterung 23 des zweiten Endes 15₁ des zweiten Federarms 3₁ fest verbunden sind.

In den Vertiefungen 29₂ und 29₃ an den ersten Enden 6₂ und 6₃ der weiteren zweiten Federarme 3₂ bzw. 3₃ sind zugehörige laterale Erweiterungen 30₂ und 30₃ des Mittelbereiches eingeführt und gesteckt. Diese lateralen Erweiterungen 30₂ und 30₃ weisen ebenfalls die gleiche Orientierung wie die weiteren zweiten Federarme 3₂ und 3₃ auf und ragen an passenden Positionen des Mittelbereiches 1 benachbart zum zweiten Ende 7 des Mittelbereiches 1 aus dem Mittelbereich 1 heraus. Diese lateralen Erweiterungen 30₂ und 30₃ des Mittelbereiches 1 bilden mit den zugehörigen Vertiefungen 29₂ und 29₃ an den ersten Enden 6₂ und 6₃ der weiteren zweiten Federarme 3₂ bzw. 3₃ jeweils eine Steckverbindung.

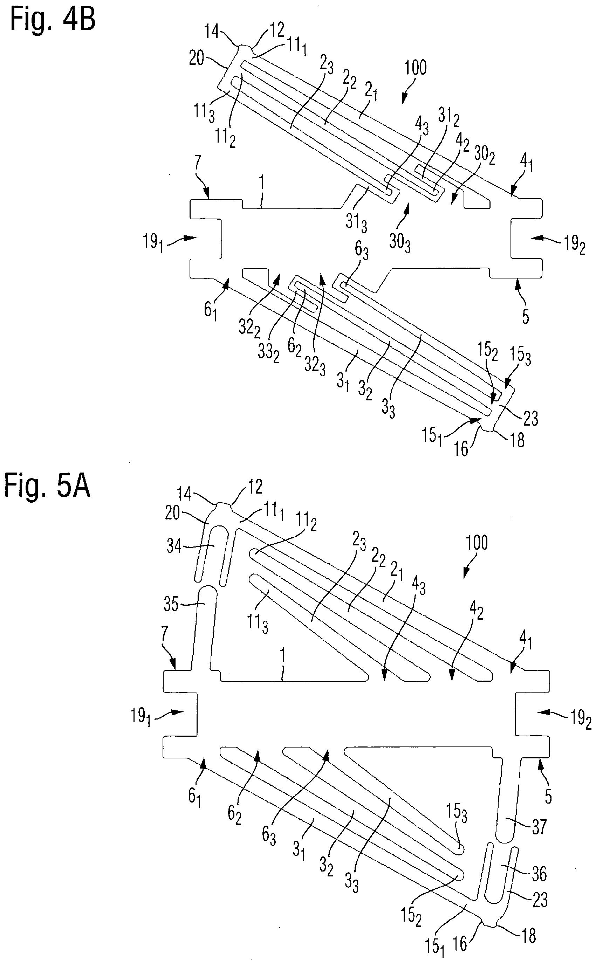

In einer zweiten Untervariante der dritten Erweiterung des erfindungsgemäßen Kontaktstiftes 100 gemäß Fig. 4B sind die zweiten Enden 11₂ und 11₃ der weiteren ersten Federarme 2₂ bzw. 2₃ fest mit der lateralen Erweiterung 20 des zweiten Endes 11₁ des ersten Federarms 2₁ verbunden, während die ersten Enden 4₂ und 4₃ der weiteren ersten Federarme 2₂ bzw. 2₃ in zugehörigen Vertiefungen 31₂ bzw. 31₃ eingeführt und gesteckt sind, die in lateralen Erweiterungen 30₂ bzw. 30₃ des Mittelbereiches 1 ausgeformt sind. Diese lateralen Erweiterungen 30₂ und 30₃ des Mittelbereiches 1 weisen mit ihren Vertiefungen 31₂ bzw. 31₃ näherungsweise eine gleiche Orientierung wie die zugehörigen weiteren ersten Federarmen 2₂ und 2₃ auf und ragen an geeigneten Positionen des Mittelbereiches 1 benachbart zum ersten Ende 5 des Mittelbereiches 1 aus dem Mittelbereich 1 heraus. Damit ist gewährleistet, dass die weiteren ersten Federarme 2₂ und 2₃ parallel zum ersten Federarm 2₁ und voneinander jeweils beabstandet durch einen Schlitz angeordnet sind, dessen durchschnittliche Breite näherungsweise der durchschnittlichen Breite der einzelnen ersten Federarme 2₁, 2₂ und 2₃ entspricht.

In einer vierten Erweiterung des erfindungsgemäßen Kontaktstiftes 100 wird im gesteckten Zustand des zu vermessenden Messobjekts im Testsockel eine zusätzliche mechanische Stabilisierung des elastisch ausgelegten erfindungsgemäßen Kontaktstiftes dadurch erzielt, dass die laterale Erweiterung 20 des zweiten Endes 11₁ des ersten Federarms 2₁ mit dem zweiten Ende 7 des Mittelbereiches 1 und die lateralen Erweiterung 23 des zweiten Endes 15₁ des zweiten Federarms 3₁ mit dem ersten Ende 5 bzw. mit dem zweiten Ende 7 des Mittelbereichs 1 jeweils in einer Steckverbindung steht.

In einer ersten Untervariante der vierten Erweiterung des erfindungsgemäßen Kontaktstiftes 100 gemäß Fig. 5A, die auf der ersten Untervariante der ersten Erweiterung des erfindungsgemäßen Kontaktstiftes gemäß Fig. 2A aufbaut, ist hierzu in der lateralen Erweiterung 20 des zweiten Endes 11₁ des ersten Federarms 2₁ eine Vertiefung 34 vorgesehen. In diese Vertiefung 34 ist eine laterale Erweiterung 35 am zweiten Ende 7 des Mittelbereiches 1 eingeführt und gesteckt. Damit es zu einer Steckverbindung zwischen der lateralen Erweiterung 35 des Mittelbereiches 1 und der Vertiefung 34 in der lateralen Erweiterung 20 des zweiten Endes 11₁ des ersten Federarms 2₁ kommt, weisen die laterale Erweiterung 35 des Mittelbereiches 1 und die Vertiefung 34 in der lateralen Erweiterung 20 des ersten Kontaktbereichs 12 im gesteckten Zustand näherungsweise eine gleiche Orientierung und eine näherungsweise zueinander korrespondierende Form auf.

Äquivalent ist in der lateralen Erweiterung 23 des zweiten Endes 15₁ des zweiten Federarms 3₁ eine Vertiefung 36 vorgesehen, in die eine laterale Erweiterung 37 am ersten Ende 5 des Mittelbereiches 1 eingeführt und gesteckt ist. Auch die Vertiefung 36 in der lateralen Erweiterung 23 des zweiten Endes 15₁ des zweiten Federarms 3₁ und die laterale Erweiterung 37 des Mittelbereiches 1 weisen näherungsweise gleiche Orientierung und näherungsweise eine zueinander korrespondierende Form auf, damit eine Steckverbindung zwischen der lateralen Erweiterung 37 des Mittelbereiches 1 und der Vertiefung 36 in der lateralen Erweiterung 23 des zweiten Endes 15₁ des zweiten Federarms 3₁ sicher zustande kommt.

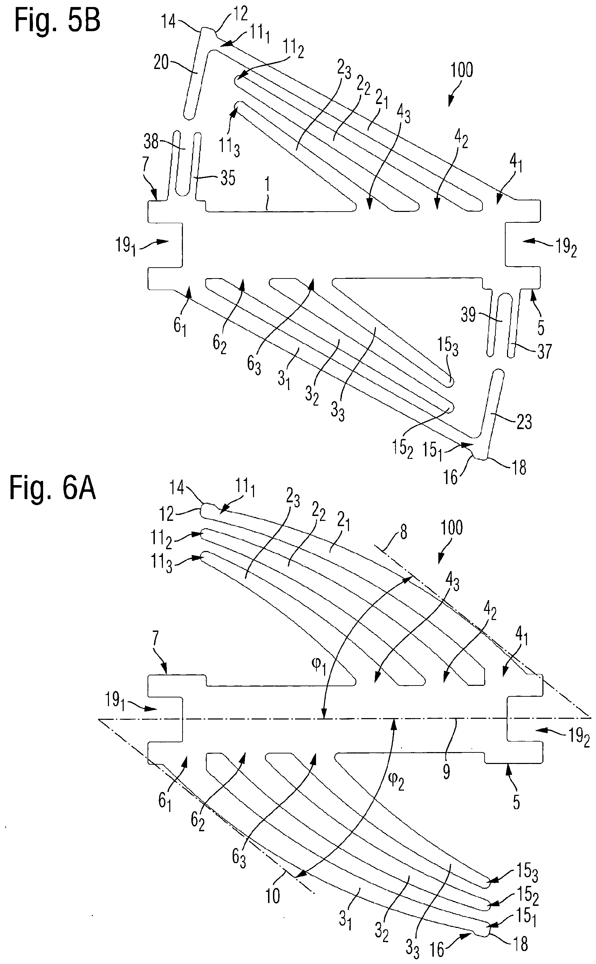

In der zweiten Untervariante der vierten Erweiterung des erfindungsgemäßen Kontaktstiftes 100 gemäß Fig. 5B ist die laterale Erweiterung 20 des zweiten Endes 11₁ des ersten Federarms 2₁ in einer Vertiefung 38, die in einer lateralen Erweiterung 35 am zweiten Ende 7 des Mittelbereiches 1 ausgeformt ist, eingeführt und gesteckt. Damit es zu einer sicheren Steckverbindung zwischen der lateralen Erweiterung 20 des zweiten Endes 11₁ des ersten Federarms 2₁ und der Vertiefung 38 in der lateralen Erweiterung 35 des Mittelbereiches 1 kommt, weisen die laterale Erweiterung 20 und die Vertiefung 38 im gesteckten Zustand näherungsweise eine gleiche Orientierung und näherungsweise jeweils zueinander korrespondierende Formen auf.

Äquivalent ist die laterale Erweiterung 23 des zweiten Endes 15₁ des zweiten Federarms 3₁ in einer Vertiefung 39 eingeführt und gesteckt, die in einer lateralen Erweiterung 37 am ersten Ende 5 des Mittelbereiches 1 ausgeformt ist. Auch für die Steckverbindung zwischen der Erweiterung 23 und der Vertiefung 39 gilt, dass die Orientierungen der Erweiterung 23 und der Vertiefung 39 näherungsweise gleich sind und die Formen der Erweiterung 23 und der Vertiefung 39 näherungsweise zueinander korrespondierende Formen aufweisen. Während in einer ersten Ausprägungsform des erfindungsgemäßen Kontaktstiftes 100 die einzelnen ersten und zweiten Federarme jeweils einen linearen Verlauf, d.h. einen geradlinigen Verlauf, aufweisen, sind in einem zweiten, nicht erfindungsgemäßen Beispiel des Kontaktstiftes 100 gemäß Fig. 6A alle ersten Federarme 2₁, 2₂ und 2₃ und alle zweiten Federarme 3₁, 3₂ und 3₃ jeweils konkav zum Mittelbereich 1 gebogen. Die Orientierung der einzelnen ersten Federarme 2₁, 2₂ und 2₃ und der einzelnen zweiten Federarme 3₁, 3₂ und 3₃ im Bereich des jeweiligen ersten Endes 4₁, 4₂ und 4₃ bzw. 6₁, 6₂ und 6₃ zur Längsachse 9 des Mittelbereichs 1 ergibt sich aus dem Winkel φ₁ bzw. φ₂ zwischen der Tangente an die einzelnen ersten Federarme 2₁, 2₂ und 2₃ und der einzelnen zweiten Federarme 3₁, 3₂ und 3₃ im Bereich des jeweiligen ersten Endes 4₁, 4₂ und 4₃ bzw. 6₁, 6₂ und 6₃ und der Längsachse 9 des Mittelbereichs 1. Bei der ersten Ausprägungsform des erfindungsgemäßen Kontaktstiftes 100 sind die Winkel φ₁ und φ₂ jeweils kleiner oder gleich 90°.

Auch in dem zweiten Beispiel des Kontaktstiftes 100 ist eine Anordnung mit einer beliebigen Anzahl von im erfindungsgemäßen Kontaktstift 100 jeweils realisierbaren ersten und zweiten Federarmen, insbesondere mit einem einzigen ersten und einem einzigen zweiten Federarm, abgedeckt.

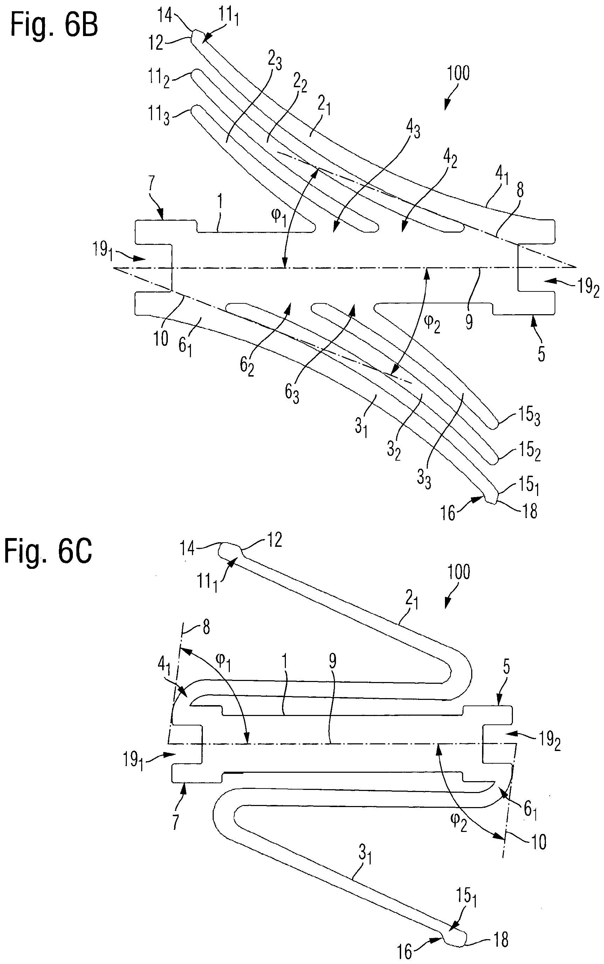

In einem dritten Beispiel eines nicht erfindungsgemäßen Kontaktstiftes 100 gemäß Fig. 6B sind die einzelnen Federarme 2₁, 2₂ und 2₃ und die einzelnen zweiten Federarme 3₁, 3₂ und 3₃ jeweils konvex zum Mittelbereich 1 gebogen. Die Orientierung der einzelnen ersten Federarme 2₁, 2₂ und 2₃ und der einzelnen zweiten Federarme 3₁, 3₂ und 3₃ im Bereich des jeweiligen ersten Endes 4₁, 4₂ und 4₃ bzw. 6₁, 6₂ und 6₃ des jeweiligen ersten bzw. zweiten Federarms 2₁, 2₂ und 2₃ bzw. 3₁, 3₂ und 3₃ zum Mittelbereich 1 ergibt sich aus dem Winkel φ₁ bzw. φ₂ zwischen der Tangente an die einzelnen ersten Federarme 2₁, 2₂ und 2₃ und der einzelnen zweiten Federarme 3₁, 3₂ und 3₃ im Bereich des jeweiligen ersten Endes 4₁, 4₂ und 4₃ bzw. 6₁, 6₂ und 6₃ und der Längsachse 9 des Mittelbereichs 1. Bei der ersten Ausprägungsform des erfindungsgemäßen Kontaktstiftes 100 sind die Winkel φ₁ und φ₂ jeweils kleiner oder gleich 90°.

Für das dritte Beispiel des Kontaktstiftes 100 ist ebenfalls eine beliebige Anzahl von im erfindungsgemäßen Kontaktstift 100 jeweils realisierbaren ersten und zweiten Federarme, insbesondere eines einzigen ersten und einzigen zweiten Federarms, mit abgedeckt.

In dem vierten, nicht erfindungsgemäßen Beispiel des Kontaktstiftes 100 sind der erste Federarm 2₁ und der zweite Federarm 3₁ gemäß Fig. 6C jeweils mäanderförmig geformt. Wie aus Fig. 6C hervorgeht, ist das erste Ende 4₁ des ersten Federarms 2₁ am zweiten Ende 7 des Mittelbereiches 1 und das erste Ende 6₁ des zweiten Federarms 3₁ am ersten Ende 5 des Mittelbereiches 1 mit dem Mittelbereich 1 verbunden. Alternativ können die ersten Enden 4₁ und 6₁ des ersten bzw. zweiten Federarms 2₁ bzw. 3₁ auch am entgegengesetzten Ende 5 bzw. 7 mit dem Mittelbereich 1 verbunden sein.

Zusätzlich zum ersten und zweiten mäanderförmig geformten Federarm 2₁ und 3₁ können weitere in Fig. 6C nicht dargestellte erste und zweite Federarme vorgesehen sein, die parallel zum ersten Federarm 2₁ bzw. zum zweiten Federarm 3₁ und durch ein Schlitz jeweils voneinander getrennt mit dem Mittelbereich 1 verbunden sind. Diese weiteren ersten und zweiten Federarme verlaufen nicht vollständig mäanderförmig und erstrecken sich nur bis zu einem Bereich zwischen der ersten und zweiten Windung des ersten und zweiten Federarms 2₁ und 3₁ entlang des ersten bzw. zweiten Federarms 2₁ bzw. 3₁.

Die Orientierung des ersten Federarms 2₁ und des zweiten Federarms 3₁ im Bereich des jeweiligen ersten Endes 4₁ bzw. 6₁ des ersten bzw. zweiten Federarms 2₁ bzw. 3₁ zum Mittelbereich 1 ergibt sich aus dem Winkel φ₁ bzw. φ₂ zwischen der Tangente an die einzelnen ersten Federarme 2₁, 2₂ und 2₃ und der einzelnen zweiten Federarme 3₁, 3₂ und 3₃ im Bereich des jeweiligen ersten Endes 4₁, 4₂ und 4₃ bzw. 6₁, 6₂ und 6₃ und der Längsachse 9 des Mittelbereichs 1. Bei der vierten Ausprägungsform des erfindungsgemäßen Kontaktstiftes 100 sind die Winkel Φ₁ und φ₂ jeweils kleiner oder gleich 90°.

Beim Eindrücken eines zu vermessenden Messobjekts in den Testsockel führen der erste Kontaktbereich 12 des ersten Federarms 2₁ und der zweite Kontaktbereich 16 des zweiten Federarms 3₁ jeweils eine rotatorische Bewegung um ihr Rotationszentrum durch, das entlang der Längsachse 8 des ersten Federarms 2₁, d.h. der Achse zwischen dem ersten Ende 4₁ und dem zweiten Ende 11₁ des ersten Federarms 2₁, bzw. entlang der Längsachse 10 des zweiten Federarms 3₁, d.h. der Achse zwischen dem ersten Ende 6₁ und dem zweiten Ende 15₁ des zweiten Federarms 3₁, wandert.

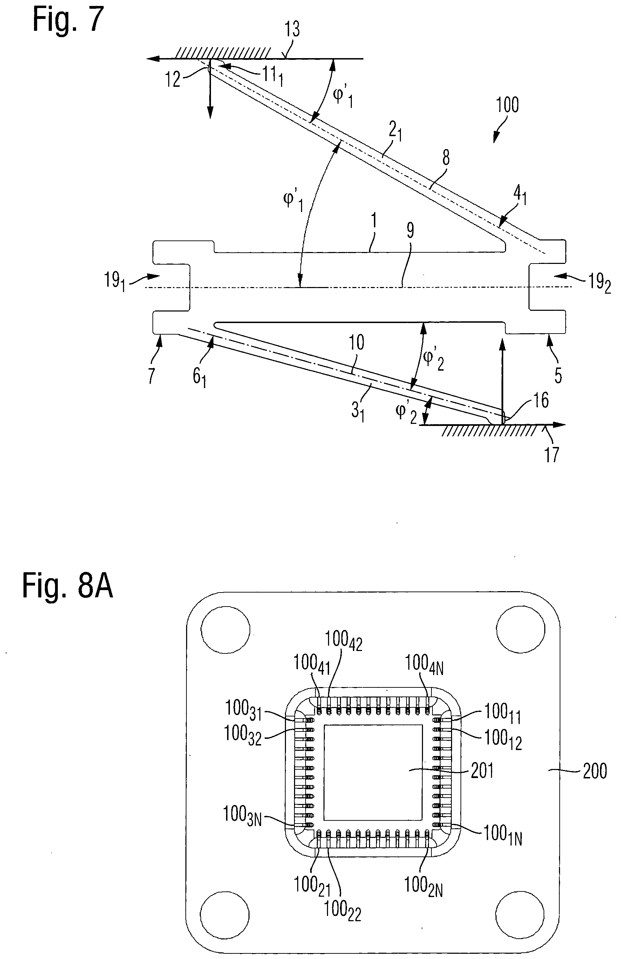

Diese rotatorische Bewegung des ersten Kontaktbereichs 12 des ersten Federarms 2₁ und des zweiten Kontaktbereichs 16 des zweiten Federarms 3₁ lässt sich jeweils, wie in Fig. 7 dargestellt ist, in zwei translatorische Bewegungskomponenten zerlegen, nämlich in eine parallel zur ersten bzw. zweiten Kontaktfläche 13 bzw. 17 verlaufende translatorische Bewegungskomponente und in eine senkrecht zur ersten bzw. zweiten Kontaktfläche 13 bzw. 17 verlaufende translatorische Bewegungskomponente.

Die translatorische Bewegung des ersten Kontaktbereichs 12, die parallel zur ersten Kontaktfläche 13 verläuft, ist aufgrund des dabei auftretenden vorteilhaften Abschabens von Belägen auf der ersten Kontaktfläche 13 durchaus erwünscht. Die translatorische Bewegung des zweiten Kontaktbereichs 16, die parallel zur zweiten Kontaktfläche 17 verläuft, ist dagegen trotz des Abriebs von störenden Belägen auf der zweiten Kontaktfläche 17 nicht so sehr erwünscht.

Während die erste Kontaktfläche 13 jedes in den Testsockel eingedrückten Messobjekts einen derartigen Abreibvorgang beim Eindrücken des Messobjekts in den Testsockel erfährt, wird die zweite Kontaktfläche 17 im Testsockel nur bei der Montage des Testsockels auf die Lastplatte einem derartigen Abreibvorgang unterworfen..

Somit ist im Bereich der zweiten Kontaktfläche 17, wie in Fig. 7 durch die deutlich kürzere Länge des horizontalen Pfeiles an der Kontaktzone 18 des zweiten Kontaktbereichs 16 angedeutet ist, eine deutlich kleinere Abreibbewegung als im Bereich der ersten Kontaktfläche 13 gewünscht, wie in Fig. 7 durch die deutlich größere Länge des horizontalen Pfeiles an der Kontaktspitze 14 des ersten Kontaktbereichs 12 zu erkennen ist.

Um eine parallel zur zweiten Kontaktfläche 16 verlaufende translatorische Abreibbewegung des zweiten Kontaktbereichs 16 zu realisieren, die deutlich kürzer als die parallel zur ersten Kontaktfläche 13 verlaufende translatorische Abreibbewegung des ersten Kontaktbereichs 12 ist, ist der Orientierungswinkel φ₂' zwischen der Längsachse 10 des zweiten Federarms 3₁ und der Längsachse 9 des Mittelbereichs 1 deutlich kleiner als der Orientierungswinkel φ₁' zwischen der Längsachse 8 des ersten Federarms 2₁ und der Längsachse 9 des Mittelbereichs 1 zu gestalten.

Für die Dimensionierung der Orientierungswinkel φ₁' und φ₂' des ersten Federarms 2₁ bzw. des zweiten Federarms 3₁ sind bevorzugt folgende Parametrierungen durchzuführen:
Der Winkel φ₁' zwischen der Längsachse 8 des Federarms 2₁ und der Längsachse 9 des Mittelbereichs 1 ist beispielsweise um den Faktor 1,5 größer als der Winkel φ₂' zwischen der Längsachse 10 des zweiten Federarms 3₁ und der Längsachse des Mittelbereichs. Der Winkel φ₁' zwischen der Längsachse 8 des Federarms 2₁ und der Längsachse 9 des Mittelbereichs 1 ist bevorzugt um den Faktor 2,0 größer als der Winkel φ₂' zwischen der Längsachse 10 des zweiten Federarms 3₁ und der Längsachse 9 des Mittelbereichs 1. Der Winkel φ₁' zwischen der Längsachse 8 des Federarms 2₁ und der Längsachse 9 des Mittelbereichs 1 ist besonders bevorzugt um den Faktor 2,5 größer als der Winkel φ₂' zwischen der Längsachse 10 des zweiten Federarms 3₁ und der Längsachse 9 des Mittelbereichs 1.

Die senkrecht zur ersten und zweiten Kontaktfläche 13 und 17 jeweils verlaufenden Bewegungskomponenten des ersten bzw. zweiten Kontaktbereichs 12 bzw. 16 sind bei den obig empfohlenen Parametrierungen für den Orientierungswinkel φ₁' zwischen der Längsachse 8 des Federarms 2₁ und der Längsachse 9 des Mittelbereichs 1 und für den Orientierungswinkel φ₂' zwischen der Längsachse 8 des Federarms 2₁ und der Längsachse 9 des Mittelbereichs 1 näherungsweise gleich, wie aus Fig. 7 zu erkennen ist.

Im Fall der ersten Ausprägungsform des erfindungsgemäßen Kontaktstiftes, d.h. bei näherungsweise linearen Verlauf des ersten und zweiten Federarms 2₁ und 2₂ entsprechen die Orientierungswinkel φ₁' und φ₂' zwischen der Längsachse 8 des ersten Federarms 2₁ bzw. der Längsachse 10 des zweiten Federarms 3₁ und der Längsachse 9 des Mittelbereichs 1 den zugehörigen Orientierungswinkeln φ₁ und φ₂ des ersten Federarms 2₁ bzw. des zweiten Federarms 3₁ im Bereich des ersten Endes 4₁ des ersten Federarms 2₁ bzw. im Bereich des ersten Endes 6₁ des zweiten Federarms 3₁.

Im Fall der zweiten Ausprägungsform (konkav gebogene Federarme), der dritten Ausprägungsform (konvex gebogenen Federarmen) und der vierten Ausprägungsform (mäanderförmige gestaltete Federarme) liegt ein derartiger Zusammenhang nicht mehr vor. Die Orientierungswinkel φ₁' und φ₂' zwischen der Längsachse 8 des ersten Federarms 2₁ bzw. der Längsachse 10 des zweiten Federarms 3₁ und der Längsachse 9 des Mittelbereichs 1 müssen separat zu den zugehörigen Orientierungswinkein φ₁ und φ₂ des ersten Federarms 2₁ bzw. des zweiten Federarms 3₁ im Bereich des ersten Endes 4₁ des ersten Federarms 2₁ bzw. im Bereich des ersten Endes 6₁ des zweiten Federarms 3₁ eingestellt werden.

Aus Fig. 9 gehen in gestrichelten Linien die einzelnen Signalpfade im erfindungsgemäßen Kontaktstift hervor, falls das zu vermessende Testobjekt in den Testsockel gedrückt ist und sich der erfindungsgemäße Kontaktstift somit im komprimierten Zustand befindet. In Fig. 9 ist eine Kombination einer ersten Erweiterung des erfindungsgemäßen Kontaktstiftes (mehrere parallele erste und zweite Federarme) und einer vierten Erweiterung des erfindungsgemäßen Kontaktstiftes (zusätzliche Verbindung des zweiten Endes des ersten und zweiten Federarms mit dem zweiten bzw. ersten Ende des Mittelbereichs) und die Verwendung der zweiten Ausprägungsform für einen erfindungsgemäßen Kontaktstift (konkav gebogene erste und zweite Federarme) dargestellt.

Die parallelen Signalpfade verkürzen einerseits die Signalwege des Hochfrequenzsignals zwischen ersten und zweiten Kontaktbereich und vermindern andererseits die ohmschen Verluste innerhalb des Kontaktstifts. Insgesamt wird die Hochfrequenz-Übertragungscharakteristik des erfindungsgemäßen Kontaktstifts damit deutlich verbessert.

Im Folgenden wird der erfindungsgemäße Testsockel anhand der Figuren 8A bis 8D im Detail erläutert:
Die Draufsicht der Fig. 8A zeigt einen erfindungsgemäßen Testsockel 200, in dessen Zentrum ein Steckplatz 201 für ein zu vermessenden Messobjekts, insbesondere für eine zu vermessende integrierte Schaltung. Die in Fig. 8A nicht dargestellte integrierte Schaltung weist im Wesentlichen eine quadratische Grundfläche auf, an deren Unterseite im Bereich der vier Seiten jeweils eine bestimmte Anzahl von ersten Kontaktflächen 13 vorgesehen ist. Alternativ kann auch eine beliebig dimensionierte rechteckige Grundfläche vorliegen, an deren Unterseite im Bereich von zwei oder vier Seiten jeweils eine bestimmte Anzahl von ersten Kontaktflächen 13 vorgesehen ist. Die an der Unterseite der integrierten Schaltung vorgesehenen ersten Kontaktflächen 13 stehen, falls die integrierte Schaltung im Steckplatz 201 des erfindungsgemäßen Testsockel 200 gesteckt ist, mit zugehörigen erfindungsgemäßen Kontaktstiften 100 jeweils in einen elektrischen Kontakt.

Hierzu sind, wie in Fig. 8A dargestellt ist, in insgesamt vier Reihen jeweils eine bestimmte Anzahl N von erfindungsgemäßen Kontaktstiften 100₁₁, 100₁₂, ..., 100_{1N}, 100₂₁, 100₂₂, ..., 100_{2N}, 100₃₁, 100₃₂, ..., 100_{3N}, 100₄₁, 100₄₂, ..., 100_{4N} angeordnet. Bei im Testsockel 200 gesteckter integrierter Schaltung befinden sich innerhalb des Testsockels 200 die in insgesamt vier Reihen jeweils angeordneten Kontaktstifte somit jeweils unterhalb der vier Reihen von ersten Kontaktflächen 13, die an der Unterseite an den vier Seitenrändern der zu vermessenden integrierten Schaltung vorgesehen sind. Zusätzlich können auch im Bereich innerhalb der vier Reihen, insbesondere im Zentrum, Kontaktstifte verteilt sein, die mit korrespondierenden ersten Kontaktflächen in einem elektrischen Kontakt stehen.

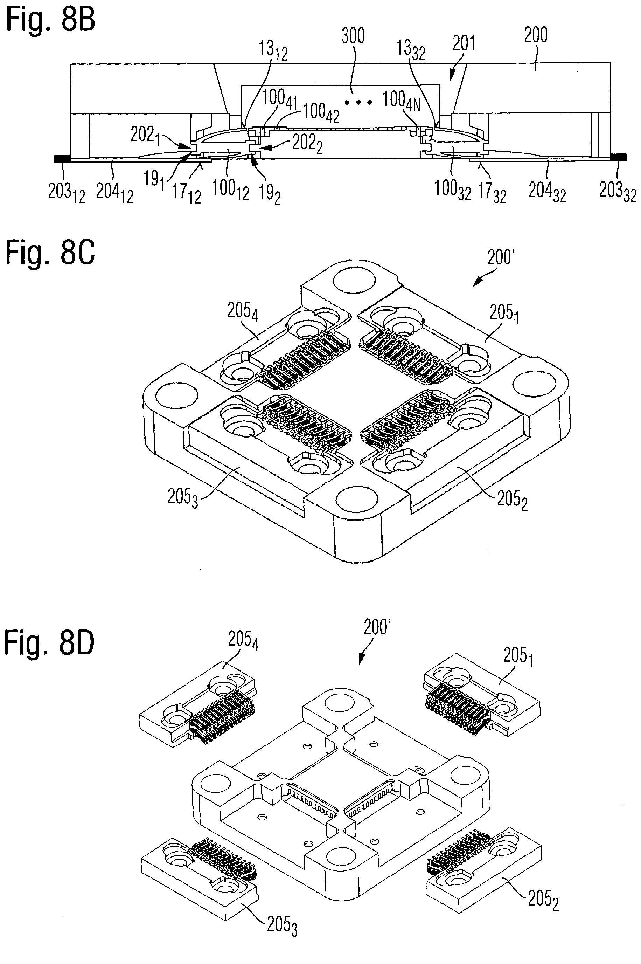

In der seitlichen Querschnittsdarstellung des erfindungsgemäßen Testsockels 200 gemäß Fig. 8B ist das zu vermessende Messobjekt 300, d.h. die zu testende integrierte Schaltung 300, in einem Steckplatz 201 gesteckt. In dieser Darstellung sind beispielhaft die beiden erfindungsgemäßen Kontaktstifte 100₁₂ und 100₃₂ in der Seitenansicht und die erfindungsgemäßen Kontaktstifte 100₄₁, 100₄₂, ..., 100_{4N} in der Frontansicht dargestellt.

Während der erfindungsgemäße Kontaktstift 100₁₂ im Testsockel 200 mit seinem ersten Kontaktbereich 12 mit der ersten Kontaktfläche 13₁₂ der zu testenden integrierten Schaltung 300 und mit seinem zweiten Kontaktbereich 16 mit der zweiten Kontaktfläche 17₁₂ jeweils in einen elektrischen Kontakt steht, besteht zwischen dem ersten Kontaktbereich 12 des erfindungsgemäßen Kontaktstift 100₃₂ und der ersten Kontaktfläche 13₃₂ der zu testenden integrierten Schaltung 300 und zwischen dem zweiten Kontaktbereichs 16 des erfindungsgemäßen Kontaktstiftes 100₃₂ und der zweiten Kontaktfläche 17₃₂ im Testsockel 200 jeweils ein elektrischer Kontakt.

Idealerweise erstrecken sich die einzelnen zweiten Kontaktflächen 17 bis an die Unterseite des erfindungsgemäßen Testsockels 200 und bilden dort elektrische Anschlüsse für eine jeweilige Verbindung zum Loadboard, einer als Lastplatte bezeichnete Leiterplatte. Dieses Loadboard ist entweder mit dem erfindungsgemäßen Testsockel mechanisch und elektrisch verbunden oder separat zum Testsockel und zum Messgerät positioniert und mit dem Testsockel bzw. dem Messgerät jeweils über elektrische Leitungen verbunden.

Alternativ können, wie in Fig. 8B dargestellt ist, die elektrischen Anschlüsse von den zugehörigen zweiten Kontaktflächen distanziert im erfindungsgemäßen Testsockel angeordnet sein. In diesem Fall sind die beiden zweiten Kontaktflächen 17₁₂ und 17₃₂ jeweils über eine elektrische Signalleitung 204₁₂ bzw. 204₃₂ mit den elektrischen Anschlüssen 203₁₂ bzw. 203₃₂ elektrisch verbunden. Über diese elektrischen Anschlüsse 203₁₂ und 203₃₂ werden zwischen dem "Loadboard" und den ersten Kontaktflächen 13₁₂ bzw. 13₃₂ der zu testenden integrierten Schaltung 300 Test- oder Messsignale zu Testzwecken ausgetauscht.

Am Beispiel des erfindungsgemäßen Kontaktstiftes 100₁₂ wird die mechanische Befestigung des erfindungsgemäßen Kontaktstiftes 100₁₂ mit dem Testsockel 200 erläutert: Die Rastmittel 19₁ und 19₂, die jeweils am ersten bzw. zweiten Ende 5 bzw. 7 des zum erfindungsgemäßen Kontaktstift 100₁₂ gehörigen Mittelbereiches 1 vorgesehen sind, stehen mit korrespondierenden Rastmitteln 202₁ und 202₂ des Testsockels 200 jeweils in einer formschlüssigen mechanischen Verbindung.

In den Figuren 8C und 8D ist jeweils eine Ausführungsform eines erfindungsgemäßen Testsockels 200' dargestellt, bei der die einzelnen erfindungsgemäßen Kontaktstifte einer Reihe jeweils in einem separierbaren Modul 205₁, 205₂, 205₃ und 205₄ integriert sind, das jeweils in den erfindungsgemäßen Testsockel 200' einlagerbar ist und damit mit den erfindungsgemäßen Testsockel 200' mechanisch verbindbar ist (siehe Fig. 8C) und jeweils aus den erfindungsgemäßen Testsockel 200' auch wieder auslagerbar ist und damit vom erfindungsgemäßen Testsockel 200' wieder mechanisch trennbar ist (siehe Fig. 8D).

Neben den einzelnen erfindungsgemäßen Kontaktstiften einer Reihe enthält ein derartiges separierbares Modul 205₁, 205₂, 205₃ und 205₄ jeweils auch die zu den einzelnen Kontaktstiften 100 jeweils gehörigen zweiten Kontaktflächen 13 und Rastmittel 202₁ und 202₂ sowie optional die elektrische Signalleitungen 204 und die elektrische Anschlüsse 205.

Zur optimalen und vor allem homogenen Temperierung aller Kontaktstifte sind bevorzugt innerhalb des Testsockels Luftkanäle vorgesehen, die über geeignet positionierte Anschlüsse am Testsockel die einzelnen Kontaktstifte mit geeignet temperierter Spülluft versorgen.

Neben der Auslagerung der in einer jeweils eine Reihe angeordneten Kontaktstifte in jeweils ein separierbares Modul 205₁, 205₂, 205₃ und 205₄ ist von der Erfindung auch die Auslagerung der in allen vier Reihen insgesamt angeordneten Kontaktstifte in jeweils einem einzigen separierbaren Modul mit abgedeckt.

Schließlich sind von der Erfindung auch Testsockel mit einer anderen Anordnung der einzelnen erfindungsgemäßen Kontaktstifte, beispielsweise in einer Matrix bzw. in einem Gitter, mit abgedeckt. Auch hierbei ist die Möglichkeit der Integration aller erfindungsgemäßen Kontaktstifte in einem einzigen separierbaren Modul oder die Integration von Teilbereichen von jeweils benachbarten erfindungsgemäßen Kontaktstiften in jeweils einem separierbaren Modul von der Erfindung mit abgedeckt.

Die Erfindung ist nicht auf die dargestellten Ausprägungsformen, Varianten und Untervarianten beschränkt. Von der Erfindung sind insbesondere alle Kombinationen der in der Beschreibung jeweils offenbarten Merkmale, der in den Patentansprüchen jeweils beanspruchten Merkmale und der in den Figuren der Zeichnung jeweils dargestellten Merkmale mit abgedeckt, soweit sie technisch sinnvoll sind und durch die vorliegenden Ansprüche abgedeckt werden.

## Patentansprüche

1. Kontaktstift (100; 100₁₂, 100₃₂) zum elektrischen Verbinden einer an einem zu vermessenden Messobjekt (300) angeordneten ersten elektrischen Kontaktfläche (13) und einer in einem Testsockel (200; 200') angeordneten zweiten elektrischen Kontaktfläche (17) mit einem länglichen Mittelbereich (1), der mit dem Testsockel (200; 200') mechanisch verbunden ist, einem ersten Federarm (2₁), dessen erstes Ende (4₁) mit einem ersten Ende (5) des Mittelbereichs (1) verbunden ist und dessen zweites Ende (11₁) einen ersten Kontaktbereich (12) zum elektrischen Kontaktieren mit der ersten elektrischen Kontaktfläche (13) aufweist, und einem zweiten Federarm (3₁), dessen erstes Ende (6₁) mit einem ersten oder zweiten Ende (5, 7) des Mittelbereichs (1) verbunden ist und dessen zweites Ende (15₁) einen zweiten Kontaktbereich (16) zum elektrischen Kontaktieren mit der zweiten elektrischen Kontaktfläche (17) aufweist, wobei der erste und der zweite Federarm (2₁, 3₁) jeweils im Bereich seines ersten Endes (4₁, 6₁) in einen Winkel (**φ**₁, **φ**₂) zu einer Längsachse (9) des Mittelbereichs (1) orientiert ist, der kleiner oder gleich 90° ist,
**dadurch gekennzeichnet,**
**dass** das zweite Ende (111) des ersten Federarms (21) mit dem zweiten Ende (7) des Mittelbereichs (1) und/oder das zweite Ende (151) des zweiten Federarms (31) mit dem zweiten Ende (7) bzw. mit dem ersten Ende (5) des Mittelbereichs (1) jeweils über eine Steckverbindung verbunden sind.

2. Kontaktstift (100; 100₁₂, 100₃₂) nach Patentanspruch 1, **dadurch gekennzeichnet,**
**dass** das zweite Ende (11₁) des ersten Federarms (2₁) eine laterale Erweiterung (20) mit einer Vertiefung (34), in die eine zugehörige laterale Erweiterung (35) des zweiten Endes (7) des Mittelbereichs (1) gesteckt ist, und das zweite Ende (15₁) des zweiten Federarms (3₁) eine laterale Erweiterung (23) mit einer Vertiefung (36) aufweisen, in die eine zugehörige laterale Erweiterung (37) des zweiten Endes (7) bzw. des ersten Endes (5) des Mittelbereichs (1) gesteckt ist.

3. Kontaktstift (100; 100₁₂, 100₃₂) nach Patentanspruch 1, **dadurch gekennzeichnet,**
**dass** das zweite Ende (11₁) des ersten Federarms (2₁) eine laterale Erweiterung (20), die in eine zugehörige Vertiefung (38) in einer lateralen Erweiterung (35) des zweiten Endes (7) des Mittelbereichs (1) gesteckt ist, und das zweite Ende (15₁) des zweiten Federarms (3₁) eine laterale Erweiterung (23) aufweisen, die in eine zugehörige Vertiefung (39) in einer lateralen Erweiterung (37) des ersten bzw. zweiten Endes (5, 7) des Mittelbereichs (1) gesteckt ist.

4. Kontaktstift (100; 100₁₂, 100₃₂) nach Patentanspruch 2 oder 3,
**dadurch gekennzeichnet,**
**dass** parallel zum ersten und zweiten Federarm (2₁ ,3₁) jeweils mindestens ein weiterer erster Federarm (2₂, 2₃) bzw. mindestens ein weiterer zweiter Federarm (3₂, 3₃) über dessen erstes Ende (4₂, 4₃, 6₂, 6₃) mit dem Mittelbereich (1) verbunden ist, die jeweils durch einen Schlitz voneinander beabstandet sind.

5. Kontaktstift (100; 100₁₂, 100₃₂) nach Patentanspruch 4, **dadurch gekennzeichnet,**
**dass** die zweiten Enden (112, 113, 152, 153) der weiteren ersten Federarme (22, 23) und der weiteren zweiten Federarme (32, 33) jeweils mit dem ersten bzw. zweiten Federarm (21, 31) verbunden sind, wenn das Messobjekt (300) in den Testsockel (200; 200') gedrückt ist.

6. Kontaktstift (100; 100₁₂, 100₃₂) nach Patentanspruch 4, **dadurch gekennzeichnet,**
**dass** die zweiten Enden (11₂, 11₃, 15₂, 15₃) der weiteren ersten Federarme (2₂, 2₃) und der weiteren zweiten Federarme (3₂, 3₃) mit der lateralen Erweiterung (20, 23) des zweiten Endes (11₁, 15₁) des ersten Federarms (2₁) bzw. des zweiten Federarms (3₁) jeweils verbunden sind.

7. Kontaktstift (100; 100₁₂, 100₃₂) nach Patentanspruch 6, **dadurch gekennzeichnet,**
**dass** das zweite Ende (11₂, 11₃, 15₂, 15₃) jedes weiteren ersten Federarms (2₂, 2₃) und jedes weiteren zweiten Federarms (3₂, 3₃) jeweils in einer zugehörigen in der lateralen Erweiterung (20, 23) des zweiten Endes (11₁, 15₁) des ersten Federarms (2₁) bzw. des zweiten Federarms (3₁) ausgeformten Vertiefung (21₂, 21₃, 22₂, 22₃) gesteckt ist.

8. Kontaktstift (100; 100₁₂, 100₃₂) nach Patentanspruch 6, **dadurch gekennzeichnet,**
**dass** in einer am zweiten Ende (11₂, 11₃, 15₂, 15₃) jedes weiteren ersten Federarms (2₂, 2₃) und jedes weiteren zweiten Federarms (3₂, 3₃) jeweils ausgeformten Vertiefung (24₂, 24₃, 27₂, 27₃) jeweils eine zugehörige stiftförmige Erweiterung (25₂, 25₃, 26₂, 26₃) gesteckt ist, die jeweils an der lateralen Erweiterung (20, 23) des zweiten Endes (11₁, 15₁) des ersten Federarms (2₁) bzw. des zweiten Federarms (3₁) zusätzlich ausgeformt ist.

9. Kontaktstift (100; 100₁₂, 100₃₂) nach einem der Patentansprüche 4 bis 8,
**dadurch gekennzeichnet,**
**dass** das erste Ende (4₂, 4₃, 6₂, 6₃) jedes weiteren ersten Federarms (2₂, 2₃) und jedes weiteren zweiten Federarms (3₂, 3₃) jeweils eine stiftförmige Erweiterung aufweist, die in eine zugehörige im Mittelbereich (1) ausgeformte Vertiefung (31₂, 31₃, 33₂, 33₃) gesteckt ist.

10. Kontaktstift (100; 100₁₂, 100₃₂) nach einem der Patentansprüche 4 bis 8,
**dadurch gekennzeichnet,**
**dass** am ersten Ende (4₂, 4₃, 6₂, 6₃) jedes weiteren ersten Federarms (2₂, 2₃) und jedes weiteren zweiten Federarms (3₂, 3₃) jeweils eine Vertiefung (27₂, 27₃, 29₂, 29₃) ausformt ist, in die jeweils eine zugehörige laterale Erweiterung (28₂, 28₃, 30₂, 30₃) des Mittelbereichs (1) gesteckt ist.

11. Kontaktstift (100; 100₁₂, 100₃₂) nach einem der Patentansprüche 1 bis 10,
**dadurch gekennzeichnet,**
**dass** ein Winkel (**φ**₁') zwischen einer Achse (8), die zwischen dem ersten und zweiten Ende (4₁, 11₁) des ersten Federarms (2₁) verläuft, und der Längsachse (9) des Mittelbereichs (1) mindestens um den Faktor 1,5 größer als ein Winkel (**φ**₂') zwischen einer Achse (10), die zwischen dem ersten und zweiten Ende (6₁, 15₁) des zweiten Federarms (3₁) verläuft, und der Längsachse (9) des Mittelbereichs (1) ist.

12. Kontaktstift (100; 100₁₂, 100₃₂) nach einem der Patentansprüche 4 bis 11,
**dadurch gekennzeichnet,**
**dass** der erste Federarm (2₁) und/oder der zweite Federarm (3₁) und/oder die weiteren ersten Federarme (2₂, 2₃) und/oder die weiteren zweiten Federarme (3₂, 3₃) jeweils linear verlaufen.

13. Kontaktstift (100; 100₁₂, 100₃₂) nach einem der Patentansprüche 4 bis 11,
**dadurch gekennzeichnet,**
**dass** der erste Federarm (2₁) und/oder der zweite Federarm (3₁) und/oder die weiteren ersten Federarme (2₂, 2₃) und/oder die weiteren zweiten Federarme (3₂, 3₃) jeweils konkav gebogen zur Mittelachse (9) des Mittelbereichs (1) verlaufen.

14. Kontaktstift (100; 100₁₂, 100₃₂) nach einem der Patentansprüche 4 bis 11,
**dadurch gekennzeichnet,**
**dass** der erste Federarm (2₁) und/oder der zweite Federarm (3₁) und/oder die weiteren ersten Federarme (2₂, 2₃) und/oder die weiteren zweiten Federarme (3₂, 3₃) jeweils konvex gebogen zur Mittelchachse (9) des Mittelbereichs (1) verlaufen.

15. Kontaktstift (100; 100₁₂, 100₃₂) nach einem der Patentansprüche 1 bis 11,
**dadurch gekennzeichnet,**
**dass** der erste Federarm (2₁) und/oder der zweite Federarm (3₁) mäanderförmig verlaufen.

16. Testsockel (200; 200') zum elektrischen Verbinden eines zu vermessenden Messobjekts (300) und einer Leiterplatte mit einer bestimmten Anzahl von Kontaktstiften (100; 100₁₂, 100₃₂) gemäß einem der Patentansprüche 1 bis 15, einer korrespondierenden Anzahl von zweiten elektrischen Kontaktflächen (17; 17₁₂, 17₃₂), die jeweils mit dem zweiten Kontaktbereich (16) des zugehörigen Kontaktstiftes (100; 100₁₂, 100₃₂) und der Leiterplatte in einem elektrischen Kontakt stehen, und mindestens einer der Anzahl von Kontaktstiften (100; 100₁₂, 100₃₂) jeweils entsprechenden Anzahl von Befestigungsvorrichtungen (202₁, 202₂) zum mechanischen Befestigen jedes einzelnen Kontaktstifts (100; 100₁₂, 100₃₂) im Testsockel (200; 200') .

17. Testsockel (200; 200') nach Patentanspruch 16,
**dadurch gekennzeichnet,**
**dass** die Kontaktstifte (100; 100₁₂, 100₃₂) mit den zugehörigen Befestigungsvorrichtungen (202₁, 202₂) und den zugehörigen zweiten elektrischen Kontaktflächen (17; 17₁₂, 17₃₂) in einem einzigen Modul angeordnet sind, das vom Testsockel (200; 200') trennbar ist.

18. Testsockel (200; 200') nach Patentanspruch 16,
**dadurch gekennzeichnet,**
**dass** mehrere Untermengen von jeweils benachbarten Kontaktstiften (100; 100₁₂, 100₃₂) mit den zugehörigen Befestigungsvorrichtungen (202₁, 202₂) und den zugehörigen zweiten elektrischen Kontaktflächen (17; 17₁₂, 17₃₂) jeweils in einem Modul (205₁, 205₂, 205₃, 205₄) angeordnet sind, das jeweils vom Testsockel (200; 200') trennbar ist.

## Claims

1. A contact pin (100; 100₁₂; 100₃₂) for electrically connecting a first electrical contact area (13) arranged on a measurement object (300) to be measured and a second electrical contact area (17) arranged in a test base (200; 200'), having an elongated central region (1), which is mechanically connected to the test base (200; 200'), having a first spring arm (2₁), the first end (4₁) of which is connected to the first end (5) of the central region (1) and the second end (11₁) of which has a first contact region (12) for electrical contact-connection with the first electrical contact area (13), and having a second spring arm (3₁), the first end (6₁) of which is connected to a first or second end (5, 7) of the central region (1) and the second end (15₁) of which has a second contact region (16) for electrical contact-connection to the second electrical contact area (17), wherein the first and the second spring arm (2₁, 3₁) are each oriented, in the region of their first end (4₁, 6₁), at an angle (Φ₁, Φ₂) in relation to a longitudinal axis (9) of the central region (1), which angle is smaller than or equal to 90°,
**characterized in**
**that** the second end (111) of the first spring arm (21) is connected with the second end (7) of the central region (1) and/or the second end (151) of the second spring arm (31) is connected with the second end (7) or with the first end (5) of the central region (1) in each case via a plug connection.

2. A contact pin (100; 100₁₂; 100₃₂) according to patent claim 1,
**characterized in**
**that** the second end (11₁) of the first spring arm (2₁) has a lateral extension (20) with a recess (34), into which an associated lateral extension (35) of the second end (7) of the central region (1) is inserted, and the second end (15₁) of the second spring arm (3₁) has a lateral extension (23) with a recess (36), into which an associated lateral extension (37) of the second end (7) or of the first end (5) of the central region (1) is inserted.

3. A contact pin (100; 100₁₂; 100₃₂) according to patent claim 1,
**characterized in**
**that** the second end (11₁) of the first spring arm (2₁) has a lateral extension (20), which is inserted into an associated recess (38) in a lateral extension (35) of the second end (7) of the central region (1), and the second end (15₁) of the second spring arm (3₁) has a lateral extension (23), which is inserted into an associated recess (39) in a lateral extension (37) of the first or second end (5, 7) of the central region (1).

4. A contact pin (100; 100₁₂; 100₃₂) according to patent claim 2 or 3,
**characterized in**
**that** parallel to the first and second spring arm (2₁, 3₁) in each case at least one further first spring arm (2₂, 2₃) or at least one further second spring arm (3₂, 3₃) is connected via its first end (4₂, 4₃, 6₂, 6₃) with the central region (1), which are in each case spaced apart from one another by a slot.

5. A contact pin (100; 100₁₂; 100₃₂) according to patent claim 4,
**characterized in**
**that** the second ends (112, 113, 152, 153) of the further first spring arms (22, 23) and the further second spring arms (32, 33) in each case are connected with the first or second spring arm (21, 31), if the measurement object (300) is pressed into the test base (200; 200').

6. A contact pin (100; 100₁₂; 100₃₂) according to patent claim 4,
**characterized in**
**that** the second ends (11₂, 11₃, 15₂, 15₃) of the further first spring arms (2₂, 2₃) and the further second spring arms (3₂, 3₃) are in each case connected with the lateral extension (20, 23) of the second end (11₁, 15₁) of the first spring arm (2₁) or of the second spring arm (3₁).

7. A contact pin (100; 100₁₂; 100₃₂) according to patent claim 6,
**characterized in**
**that** the second end (11₂, 11₃, 15₂, 15₃) of each further first spring arm (2₂, 2₃) and each further second spring arm (3₂, 3₃) is inserted in each case in an associated recess (21₂, 21₃, 22₂, 22₃) formed in the lateral extension (20, 23) of the second end (11₁, 15₁) of the first spring arm (2₁) or of the second spring arm (3₁).

8. A contact pin (100; 100₁₂; 100₃₂) according to patent claim 6,
**characterized in**
**that** in a recess (24₂, 24₃, 27₂, 27₃) in each case formed on the second end (11₂, 11₃, 15₂, 15₃) of each further first spring arm (2₂, 2₃) and of each further second spring arm (3₂, 3₃) in each case an associated pin-shaped extension (25₂, 25₃, 26₂, 26₃) is inserted, which in each case is additionally formed on the lateral extension (20, 23) of the second end (11₁, 15₁) of the first spring arm (2₁) or of the second spring arm (3₁).

9. A contact pin (100; 100₁₂; 100₃₂) according any one of patent claims 4 to 8, **characterized in**
**that** the first end (4₂, 4₃, 6₂, 6₃) of each further first spring arm (2₂, 2₃) and of each further second spring arm (3₂, 3₃) in each case has a pin-shaped extension, which is inserted into an associated recess (31₂, 31₃, 33₂, 33₃) formed in the central region (1).

10. A contact pin (100; 100₁₂; 100₃₂) according to any one of patent claims 4 to 8, **characterized in**
**that** on the first end (4₂, 4₃, 6₂, 6₃) of each further first spring arm (2₂, 2₃) and of each further second spring arm (3₂, 3₃) in each case a recess (27₂, 27₃, 29₂, 29₃) is formed, into which in each case an associated lateral extension (28₂, 28₃, 30₂, 30₃) of the central region (1) is inserted.

11. A contact pin (100; 100₁₂; 100₃₂) according to any one of patent claims 1 to 10, **characterized in**
**that** an angle (Φ₁') between an axis (8), which runs between the first and second end (4₁, 11₁) of the first spring arm (2₁), and the longitudinal axis (9) of the central region (1) is larger by at least a factor of 1.5 than an angle (Φ₂') between an axis (10), which runs between the first and second end (6₁, 15₁) of the second spring arm (3₁), and the longitudinal axis (9) of the central region (1).

12. A contact pin (100; 100₁₂; 100₃₂) according to any one of patent claims 4 to 11, **characterized in**
**that** the first spring arm (2₁) and/or the second spring arm (3₁) and/or the further first spring arms (2₂, 2₃) and/or the further second spring arms (3₂, 3₃) in each case run linearly.

13. A contact pin (100; 100₁₂; 100₃₂) according to any one of patent claims 4 to 11, **characterized in**
**that** the first spring arm (2₁) and/or the second spring arm (3₁) and/or the further first spring arms (2₂, 2₃) and/or the further second spring arms (3₂, 3₃) in each case run bent concavely to the central axis (9) of the central region (1).

14. A contact pin (100; 100₁₂; 100₃₂) according to any one of patent claims 4 to 11, **characterized in**
**that** the first spring arm (2₁) and/or the second spring arm (3₁) and/or the further first spring arms (2₂, 2₃) and/or the further second spring arms (3₂, 3₃) in each case run bent convexly to the central axis (9) of the central region (1).

15. A contact pin (100; 100₁₂; 100₃₂) according to any one of patent claims 1 to 11, **characterized in**
**that** the first spring arm (2₁) and/or the second spring arm (3₁) run in a meandering fashion.

16. A test base (200; 200') for the electrical connection of a measurement object (300) to be measured and a circuit board having a specific number of contact pins (100; 100₁₂; 100₃₂) according to any one of patent claims 1 to 15, a corresponding number of second electrical contact areas (17; 17₁₂, 17₃₂), which in each case are in an electrical contact with the second contact region (16) of the associated contact pin (100; 100₁₂; 100₃₂) and the circuit board, and at least a number of fastening devices (202₁, 202₂) in each case corresponding to the number of contact pins (100; 100₁₂; 100₃₂) for the mechanical fastening of each individual contact pin (100; 100₁₂; 100₃₂) in the test base (200; 200').

17. A test base (200; 200') according to patent claim 16,
**characterized in**
**that** the contact pins (100; 100₁₂; 100₃₂) are arranged with the associated fastening devices (202₁, 202₂) and the associated second electrical contact areas (17; 17₁₂, 17₃₂) in a single module, which can be separated from the test base (200; 200').

18. A test base (200; 200') according to patent claim 16,
**characterized in**
**that** several subsets of in each case adjacent contact pins (100; 100₁₂; 100₃₂) are in each case arranged with the associated fastening devices (202₁, 202₂) and the associated second electrical contact areas (17; 17₁₂, 17₃₂) in a module (205₁, 205₂, 205₃, 205₄), which in each case can be separated from the test base (200; 200').

## Revendications

1. Broche de contact (100; 100₁₂, 100₃₂) pour la liaison électrique d'une première surface de contact électrique (13) disposée sur un objet de mesure à mesurer (300) et d'une deuxième surface de contact électrique (17) disposée dans un socle de test (200 ; 200') avec une partie centrale allongée (1), qui est reliée mécaniquement avec le socle de test (200 ; 200'), un premier bras à ressort (2₁), dont la première extrémité (4₁) est reliée avec une première extrémité (5) de la partie centrale (1) et dont la deuxième extrémité (11₁) comprend une première partie de contact (12) pour le contact électrique avec la première surface de contact électrique (13), et un deuxième bras à ressort (3₁), dont la première extrémité (6₁) est reliée avec une première ou une deuxième extrémité (5, 7) de la partie centrale (1) et dont la deuxième extrémité (15₁) comprend une deuxième partie de contact (16) pour le contact électrique avec la deuxième surface de contact électrique (17), le premier et le deuxième bras à ressort (2₁, 3₁) étant orientés, chacun au niveau de sa première extrémité (4₁, 6₁), avec un angle (Φ₁, Φ₂) par rapport à l'axe longitudinal (9) de la partie centrale (1), qui est inférieur ou égal à 90°,
**caractérisée en ce que**
la deuxième extrémité (111) du premier bras à ressort (21) est reliée avec la deuxième extrémité (7) de la partie centrale (1) et/ou la deuxième extrémité (151) du deuxième bras à ressort (31) est reliée avec la deuxième extrémité (7) ou avec la première extrémité (5) de la partie centrale (1) par l'intermédiaire d'une liaison par enfichage.

2. Broche de contact (100 ; 100₁₂, 100₃₂) selon la revendication 1, **caractérisée en ce que**
la deuxième extrémité (11₁) du premier bras à ressort (2₁) comprend un élargissement latéral (20) avec un creux (34), dans lequel est emboîté un élargissement latéral (35) correspondant de la deuxième extrémité (7) de la partie centrale (1) et la deuxième extrémité (15₁) du deuxième bras à ressort (3₁) comprend un élargissement latéral (23) avec un creux (36), dans lequel est emboîté un élargissement latéral (37) correspondant de la deuxième extrémité (7) ou de la première extrémité (5) de la partie centrale (1).

3. Broche de contact (100 ; 100₁₂, 100₃₂) selon la revendication 1,
**caractérisée en ce que**
la deuxième extrémité (11₁) du premier bras à ressort (2₁) comprend un élargissement latéral (20), qui est emboîté dans un creux (38) correspondant dans un élargissement latéral (35) de la deuxième extrémité (7) de la partie centrale (1), et la deuxième extrémité (15₁) du deuxième bras à ressort (3₁) comprend un élargissement latéral (23) qui est emboîté dans un creux (39) correspondant dans un élargissement latéral (37) de la première ou de la deuxième extrémité (5, 7) de la partie centrale (1).

4. Broche de contact (100 ; 100₁₂, 100₃₂) selon la revendication 2 ou 3,
**caractérisée en ce que**
parallèlement au premier et au deuxième bras à ressort (2₁, 3₁), au moins un autre premier bras à ressort (2₂, 3₂) ou au moins un autre deuxième bras à ressort (4₂, 4₃, 6₂, 6₃) est relié avec la partie centrale (1), qui sont écartés entre eux par une fente.

5. Broche de contact (100 ; 100₁₂, 100₃₂) selon la revendication 4,
**caractérisée en ce que**
les deuxièmes extrémités (112, 113, 152, 153) des autres premiers bras à ressorts (22, 23) et les autres deuxièmes bras à ressorts (32, 33) sont reliées respectivement avec le premier ou le deuxième bras à ressort (21, 31) lorsque l'objet à mesurer (300) est comprimé dans le socle de test (200, 200').

6. Broche de contact (100 ; 100₁₂, 100₃₂) selon la revendication 4,
**caractérisée en ce que**
les deuxièmes extrémités (11₂, 11₃, 15₂, 15₃) des autres premiers bras à ressorts (2₂, 2₃) et des autres deuxièmes bras à ressorts (3₂, 3₃) sont reliées respectivement avec l'élargissement latéral (20, 23) de la deuxième extrémité (11₁, 15₁) du premier bras à ressort (2₁) ou du deuxième bras à ressort (3₁).

7. Broche de contact (100 ; 100₁₂, 100₃₂) selon la revendication 6,
**caractérisée en ce que**
la deuxième extrémité (11₂, 11₃, 15₂, 15₃) de chaque autre premier bras à ressort (2₂, 2₃) et de chaque autre deuxième bras à ressort (3₂, 3₃) est emboîtée respectivement dans un creux (21₂, 21₃, 22₂, 22₃) correspondant formé dans l'élargissement latéral (20, 23) de la deuxième extrémité (11₁, 15₁) du premier bras à ressort (2₁) ou du deuxième bras à ressort (3₁).

8. Broche de contact (100 ; 100₁₂, 100₃₂) selon la revendication 6,
**caractérisée en ce que**
dans un creux (24₂, 24₃, 27₂, 27₃) formé au niveau de la deuxième extrémité (11₂, 11₃, 15₂, 15₃) de chaque premier bras à ressort (2₂, 2₃) et de chaque autre deuxième brs à ressort (3₂, 3₃) est emboîté un élargissement correspondant en forme de broche (25₂, 25₃, 26₂, 26₃) qui est formé en outre au niveau de l'élargissement latéral (20, 23) de la deuxième extrémité (11₁, 15₁) du premier bras à ressort (2₁) ou du deuxième bras à ressort (3₁).

9. Broche de contact (100 ; 100₁₂, 100₃₂) selon l'une des revendications 4 à 8,
**caractérisée en ce que**
la première extrémité (4₂, 4₃, 6₂, 6₃) de chaque autre premier bras à ressort (2₂, 2₃) et de chaque autre deuxième bras à ressort (3₂, 3₃) comprend un élargissement en forme de broche qui est emboîté dans un creux correspondant (31₂, 31₃, 33₂, 33₃) formé dans la partie centrale (1).

10. Broche de contact (100 ; 100₁₂, 100₃₂) selon l'une des revendications 4 à 8,
**caractérisée en ce que**
au niveau de la première extrémité (4₂, 4₃, 6₂, 6₃) de chaque autre premier bras à ressort (2₂, 2₃) et de chaque autre deuxième bras à ressort (3₂, 3₃) est formé un creux (27₂, 27₃, 29₂, 29₃), dans lequel est emboîté un élargissement latéral (28₂, 28₃, 30₂, 30₃) de la partie centrale (1).

11. Broche de contact (100 ; 100₁₂, 100₃₂) selon l'une des revendications 1 à 10,
**caractérisée en ce que**
un angle (Φ₁') entre un axe (8), qui s'étend entre la première et la deuxième extrémité (4₁, 11₁) du premier bras à ressort (2₁), et l'axe longitudinal (9) de la partie centrale (1) est supérieur d'au moins un facteur 1,5 à un angle (Φ₂') entre un axe (10) qui s'étend entre la premier et la deuxième extrémité (6₁, 15₁) du deuxième bras à ressort (3₁) et l'axe longitudinal (9) de la partie centrale (1).

12. Broche de contact (100 ; 100₁₂, 100₃₂) selon l'une des revendications 4 à 11,
**caractérisée en ce que**
le premier bras à ressort (2₁) et/ le deuxième bras à ressort (3₁) et/ou les autres premiers bras à ressort (2₂, 2₃) et/ou les autres deuxièmes bras à ressorts (3₂, 3₃) s'étendent de manière linéaire.

13. Broche de contact (100 ; 100₁₂, 100₃₂) selon l'une des revendications 4 à 11,
**caractérisée en ce que**
le premier bras à ressort (2₁) et/ou le deuxième bras à ressort (3₁) et/ou les autres premiers bras à ressorts (2₂, 2₃) et/ou les autres deuxièmes bras à ressorts (3₂, 3₃) s'étendent avec une courbure concave par rapport à l'axe central (9) de la partie centrale (1).

14. Broche de contact (100 ; 100₁₂, 100₃₂) selon l'une des revendications 4 à 11,
**caractérisée en ce que**
le premier bras à ressort (2₁) et/ou le deuxième bras à ressort (3₁) et/ou les autres premiers bras à ressorts (2₂, 2₃) et/ou les autres deuxièmes bras à ressorts (3₂, 3₃) s'étendent avec une courbure convexe par rapport à l'axe central (9) de la partie centrale (1).

15. Broche de contact (100 ; 100₁₂, 100₃₂) selon l'une des revendications 1 à 11,
**caractérisée en ce que**
le premier bras à ressort (2₁) et/ou le deuxième bras à ressort (3₁) s'étendent en zigzag.

16. Socle de test (200 ; 200') pour la liaison électrique d'un objet de mesure à mesurer (300) et d'un circuit imprimé avec un nombre déterminé de broches de contact (100; 100₁₂, 100₃₂) selon l'une des revendications 1 à 15, un nombre correspondant de deuxièmes surfaces de contact électrique (17 ; 17₁₂, 17₃₂), qui sont chacune en contact électrique avec la deuxième partie de contact (16) de la broche de contact (100 ; 100₁₂, 100₃₂) correspondante et le circuit imprimé et au moins un nombre de dispositifs de fixation (202₁, 202₂), correspondant au nombre de broches de contact (100 ; 100₁₂, 100₃₂), pour la fixation mécanique d'une broche de contact (100 ; 100₁₂, 100₃₂) dans le socle de test (200 ; 200').

17. Socle de test (200 ; 200') selon la revendication 16,
**caractérisé en ce que**
les broches de contact (100 ; 100₁₂, 100₃₂) sont disposées avec les dispositifs de fixation (202₁, 202₂) correspondants et les deuxièmes surfaces de contact électrique (17 ; 17₁₂, 17₃₂) correspondantes dans un seul module qui peut être séparé du socle de test (200 ; 200').

18. Socle de test (200 ; 200') selon la revendication 16,
**caractérisé en ce que**
plusieurs sous-groupes de broches de contact (100 ; 100₁₂, 100₃₂) adjacentes sont disposés chacun avec les dispositifs de fixation (202₁, 202₂) correspondants et les deuxièmes surfaces de contact électrique (17 ; 17₁₂, 17₃₂) correspondantes dans un module (205₁, 205₂, 205₃, 205₄), qui peut être séparé du socle de test (200 ; 200').
